# EUROPÄISCHE PATENTSCHRIFT

(11) **EP 4 050 545 B1**
(45) Veröffentlichungstag und Bekanntmachung des Hinweises auf die Patenterteilung: **20.05.2026**
(21) Anmeldenummer: 21159058.3
(22) Anmeldetag: 24.02.2021
(51) Int. Cl.: G06Q 30/0601, G06Q 50/08, G07C 9/00, G06F 30/13

(54) **VERFAHREN ZUR INSTALLATION VON MEHREREN TÜRKOMPONENTEN**
METHOD FOR THE INSTALLATION OF MULTIPLE DOOR COMPONENTS
PROCÉDÉ D'INSTALLATION D'UNE PLURALITÉ DE COMPOSANTS DE PORTE

(43) Veröffentlichungstag der Anmeldung: 31.08.2022
(60) Teilanmeldung: 26171032.1
(73) Patentinhaber: dormakaba Deutschland GmbH, 58256 Ennepetal (DE); dormakaba International Holding GmbH, 58256 Ennepetal (DE); dormakaba Schweiz AG, 8153 Rümlang (CH)
(72) Erfinder: Oberste-Ufer, Kai, 58256 Ennepetal (DE); Fischer, Daniel, 8153 Rümlang (CH); Vogler, Thomas, 58256 Ennepetal (DE); Busch, Sven, 58256 Ennepetal (DE); Halder, Ingo, 58256 Ennepetal (DE); Gehrmann, Bernd, 58256 Ennepetal (DE); Dudzinski, Andrzej, 58256 Ennepetal (DE); Gupta, Chandra Prakash, 58256 Ennepetal (DE); Borchmann, Oliver, 58256 Ennepetal (DE); Lorenz, Frank, 8153 Rümlang (CH); Simon, Jürg, 8153 Rümlang (CH)
(74) Vertreter: Balder IP Law, S.L.

(56) Entgegenhaltungen:
- EP-A1- 1 191 465
- EP-A1- 3 267 451
- EP-A1- 3 349 189
- CH-A1- 714 707
- JP-A- 2006 131 188
- US-A1- 2014 095 122

## Beschreibung

Die Erfindung betrifft ein Verfahren zur Installation von mehreren Türkomponenten.

Beispielsweise in Krankenhäusern sind mehrere Türkomponenten hintereinander oder gemeinsam an einer Tür angeordnet. Bei der Planung von solchen Türkomponenteninstallationen kann es vorkommen, dass einige Türkomponenten nicht konsistent zu anderen Türkomponenten sind oder die Türkomponenten untereinander falsch installiert sind. Dieser Umstand birgt beispielsweise bei Fluchtwegtüren die Gefahr, dass sich beispielswiese eine der Fluchtwegtüren nicht öffnet, obwohl dies erforderlich wäre. Andererseits könnte beispielsweise eine der Brandschutztüren geöffnet bleiben, obwohl diese im Brandfalle allesamt zu schließen wären. Ein weiteres Sicherheitsrisiko geht davon aus, wenn z. B. eine Zutrittskontrolle nicht, wie vorgesehen, funktioniert.

Der Erfindung liegt die Aufgabe zugrunde, ein Verfahren zur Installation von Türkomponenten anzugeben, mit welchem sichergestellt ist, dass die verwendeten Türkomponenten konsistent zueinander abgestimmt sind, und/oder welches aus sicherheitstechnischen Aspekten verbessert ist. Ebenfalls ist es Aufgabe der Erfindung ein Computerprogrammprodukt bereitzustellen, welches eine sicherheitstechnisch verbessertes Installationsverfahren ermöglicht. Ebenfalls ist es Aufgabe der Erfindung, eine Recheneinheit oder ein Zugangssystem mit einer Recheneinheit zur Verfügung zu stellen, mit welchem ein sicherheitstechnisches Installationsverfahren durchgeführt werden kann.

Die Lösung der Aufgabe gelingt mit einem Verfahren mit den Merkmalen des Anspruchs 1. Vorteilhafte Weiterbildungen des Verfahrens sind in den abhängigen Ansprüchen, der Beschreibung und in den Figuren angegeben. Merkmale und Details, die in Zusammenhang mit dem erfindungsgemäßen Verfahren beschrieben sind, gelten dabei auch in Zusammenhang mit einem erfindungsgemäßen Computerprogrammprodukt und/oder einem erfindungsgemäßen Zugangssystem und/oder einer erfindungsgemäßen Recheneinheit und umgekehrt. Insbesondere sind ein Computerprogrammprodukt, mit dem ein erfindungsgemäßes Verfahren, insbesondere ein Verfahren nach einem der Ansprüche 1 bis 13, ausführbar ist, und/oder eine Recheneinheit und/oder ein Zugangssystem, mit dem ein erfindungsgemäßes Verfahren, insbesondere ein Verfahren nach einem der Ansprüche 1 bis 13, ausführbar ist, unter Schutz gestellt. Das erfindungsgemäße Zugangssystem kann die erfindungsgemäße Recheneinheit umfassen. Ferner können das Zugangssystem und/oder die Recheneinheit zumindest einen elektronischen Speicher als computerlesbares Medium umfassen, auf dem das erfindungsgemäße Computerprogramm gespeichert ist.

Dabei können die in der Beschreibung und in den Ansprüchen erwähnten Merkmale jeweils einzeln für sich oder in Kombination erfindungswesentlich sein. Die Beschreibung charakterisiert und spezifiziert die Erfindung insbesondere im Zusammenhang mit den Figuren zusätzlich.

Es wird ein Verfahren zur Installation von mehreren Türkomponenten angegeben.

Das erfindungsgemäße Verfahren umfasst zumindest die Schritte:
a. Bereitstellen von zumindest einem vorkonfigurierten Türsystemtyp durch ein elektronisches Konfigurationssystem zur Auswahl durch einen Benutzer,
   wobei der zumindest eine vorkonfigurierte Türsystemtyp durch das elektronische Konfigurationssystem von einer Datenbank abrufbar ist,
   wobei durch zumindest eine technische und/oder funktionale Benutzervorgabe zumindest ein vorkonfigurierter Türsystemtyp durch das Konfigurationssystem vorselektierbar ist,
   wobei der Türsystemtyp mehrere festgelegte Türkomponententypen enthält,
b. Elektronische Zurverfügungstellung von vorkonfigurierten, technischen Daten des ausgewählten Türsystemtyps, um die Installation vor Ort durchzuführen.

Erfindungsgemäß stellt das Konfigurationssystem Türsystemtypen bereit. Die Türsystemtypen umfassen jeweils mehrere festgelegte Türkomponententypen. Ein Türkomponententyp ist insbesondere definiert durch die Funktion, die der Türkomponententyp in Bezug auf die Tür hat, an der die Türkomponente, die dem Türkomponententyp entspricht, zu installieren ist.

Die Funktion kann die Änderung eines Türzustands umfassen. Die Änderung des Türzustands kann z. B. einem Öffnen der Tür, einem Schließen der Tür, einem Entriegeln der Tür, einem Verriegeln der Tür, einem Bereitstellen eines Zustands für ein manuelles Entriegeln und/oder Verriegeln, für ein manuelles Öffnen und/oder Schließen der Tür entsprechen.

Beispielsweise kann die Türkomponente, die dem Türkomponententyp entspricht, einem motorischen Türantrieb sein. Der motorische Türantrieb kann ein motorisches Öffnen und/oder Schließen der Tür bewirken. In einem anderen Beispiel kann die Türkomponente, die dem Türkomponententyp entspricht, als ein elektrisch betätigbares Verriegelungselement, z. B. ein Motorschloss, einen motorischen Schließzylinder oder eine elektromagnetische Türverriegelung, ausgebildet sein. Das elektrisch betätigbares Verriegelungselement kann eine Entriegelung und/oder Verriegelung der Tür bewirken. In einem weiteren Beispiel kann die Türkomponente, die dem Türkomponententypen entspricht, als ein elektrischer Türöffner ausgebildet sein. Der elektrische Türöffner kann einen Zustand einnehmen, in denen durch eine manuelle Betätigung der Tür ein Entriegeln und ein gleichzeitiges Öffnen der Tür bewirkt wird, während in einem anderen Zustand des Türöffners eine manuelle Betätigung der Tür und damit ein Entriegeln und Öffnen der Tür verhindert ist. Weitere Beispiele für Türkomponenten für das Bereitstellen eines Zustands zum manuellen Entriegeln einer Tür sind in elektromechanischen Schließzylindern und/oder elektromechanischen Beschlägen zu sehen, die ebenfalls jeweils einem Türkomponententyp entsprechen.

Die Funktion kann eine Signalerzeugung zur Änderung des Türzustands umfassen. Die Türkomponente, die dem Türkomponententyp entspricht, kann z. B. ein Signal erzeugen, wobei das Signal verursacht, dass eine weitere Türkomponente, z. B. der motorische Türantrieb, das Verriegelungselement und/oder der Türöffner, den Türzustand ändert. Eine derartige Türkomponente wird als Signalgeber bezeichnet. Beispielsweise kann die Türkomponente, die dem Türkomponententyp entspricht, als ein Sensor ausgebildet sein, der eine Annäherung einer Person an die Tür detektiert. In einem anderen Beispiel kann die Türkomponente, die dem Türkomponententyp entspricht, als ein Handtaster oder als Schlüsseltaster ausbildet sein, durch dessen Betätigung ein Anwender seinen Öffnungswunsch dem Türsystem übermittelt. In einem weiteren Beispiel kann die Türkomponente, die dem Türkomponententyp entspricht, als ein Gefahrenmelder, beispielsweise ein Rauchmelder, ausgebildet sein. Der Signalgeber kann z. B. als Fluchtwegsteuerung ausgebildet sein, wobei die Fluchtwegsteuerung die Betätigung eines Nottasters erfasst und ein Signal, dass der Nottaster betätigt worden ist, erzeugt. In einem weiteren Beispiel kann die Türkomponente, die dem Türkomponententyp entspricht, als eine Authentifizierungsvorrichtung ausgebildet sein. Die Authentifizierungsvorrichtung überprüft eine Berechtigung des Anwenders durch die Tür zu gehen. Ist der Anwender berechtigt, so sendet die Authentifizierungsvorrichtung ein entsprechendes Signal an eine weitere Türkomponente, z. B. an einem Verriegelungselement oder einen Türöffner, die den Zutritt ermöglicht.

Des Weiteren kann die Funktion des Türkomponententyps Eigenschaften der Tür beinhalten oder auf die Eigenschaft der Tür abgestimmt sein. Die Eigenschaften der Tür können funktionellen Eigenschaften der Tür entsprechen, z. B. Schiebetüren, Drehflügeltüren und Karusselltüren. Die Eigenschaften der Tür können der Ausbildung als Vollblatt oder als Rohrrahmentür entsprechen. Die Eigenschaften der Tür können die räumlichen Maße und/oder dem Gewicht der Tür entsprechen. Beispielsweise ist kann die Leistungsstärke des Türantriebs an das Gewicht der Tür angepasst sein.

Des Weiteren kann die Funktion des Türkomponententyps funktionelle Eigenschaften des Türkomponentyps selber beinhalten. Beispiele der funktionellen Eigenschaften können z. B. "für den Fluchtweg geeignet", "für eine Brandschutztür" "selbstverriegelnd", "selbstschließend" umfassen.

Die Türkomponententypen unterscheiden sich bevorzugt dadurch, dass die Türkomponententyp untereinander jeweils eine andere Funktion und/oder eine funktionelle Eigenschaft abbilden. Somit kann z. B. ein "selbstverriegelndes Antipanikschloss mit Motor für Vollblatttüren" einen eigenen Türkomponententyp bilden. In einem anderen Beispiel kann ein "selbstschließender Drehflügeltürantrieb für den Einsatz an normalen Türen bis zu 1100 mm Breite oder 160 kg Gewicht" einen weiteren Türkomponententyp bilden.

Bevorzugt unterscheiden sich Türkomponententypen zusätzlich oder alternativ durch die Art und/oder die Anordnung der elektrischen Verbindung zu zumindest einem weiteren Türkomponente. Beispielsweise können sich die Türkomponententypen darin unterscheiden, an welcher Schnittstelle eine Verbindung zu welcher weiteren Türkomponente herzustellen ist. Somit können sich die Türkomponententypen z. B. durch eine Belegung von Anschlussklemmen unterscheiden.

Zusätzlich oder alternativ unterscheiden sich die Türkomponententypen durch die Art der elektronischen Einbindung in den Türsystemtyp. Beispielsweise können sich die Türkomponententypen darin unterscheiden, ob eine Verbindung zu zumindest einer weiteren Türkomponente über ein Bussystem erfolgt, und ggf. über welches Bussystem. Unter einer Verbindung mit einem Bussystem wird im Folgenden eine unmittelbare Verbindung verstanden, so dass eine mit dem Bussystem verbundene Komponente als Teilnehmer des Bussystems mit einer eigenen Busadresse anzusehen ist.

Damit sich die Türkomponententypen durch die Art und/oder die Anordnung der elektrischen Verbindung und/oder die elektronische Einbindung unterscheiden, bilden üblicherweise Türkompontentypen unterschiedliche Hersteller und/oder unterschiedlicher Versionen desselben Herstellers jeweils einen eigenen Türkomponententyp.

Erfindungsgemäß sind jeweils mehrere Türkomponententypen zu einem Türsystemtyp zusammengefasst.

Als Türkomponententyp wird im Rahmen dieser Offenbarung jeweils eine Art der Türkomponente mit zumindest einem, bevorzugt mehreren, der erwähnten Unterscheidungskriterien verstanden, während die Türkomponente selber die Vorrichtung des Türkomponententyps, die an der Tür konkret verbaut wird, verstanden wird. Ein Türsystemtyp umfasst mehrere Türkomponententypen, während das Türsystem selber die an der Tür konkret zu verbauenden Türkomponenten umfasst.

Ein Türsystemtyp kann zur Installation an einer Tür ausgebildet sein. Es ist denkbar, dass ein Türsystemtyp zur Installation an mehreren Türblättern ausgebildet ist. Beispielsweise kann der Türsystemtyp zur Installation an eine zweiflügelige Tür vorgesehen sein. Zusätzlich oder alternativ kann der Türsystemtyp zur Installation an mehreren, insbesondere hintereinander angeordneten, Türen vorgesehen sein. Z. B. kann hierdurch eine Schleuse gebildet werden. Zusätzlich oder alternativ kann der Türsystemtyp zur Installation von mehreren Türen an einem Gang, z. B. einem Hotelgang oder einem Büroflur, ausgebildet sein.

Es ist denkbar, dass ein Türsystemtyp mehrmals denselben Türkomponententyp umfasst, wobei mehrere Exemplare desselben Türkomponententyps an unterschiedlichen Positionen zu installieren sind. Beispielsweise kann ein Türsystemtyp jeweils einen "selbstschließender Drehflügeltürantrieb für den Einsatz an normalen Türen bis zu 1100 mm Breite oder 160 kg Gewicht mit einem CAN-Bus Anschluss" für ein erstes Türblatt einer zweiflügeligen Tür und einen "selbstschließender Drehflügeltürantrieb für den Einsatz an normalen Türen bis zu 1100 mm Breite oder 160 kg Gewicht mit einem CAN-Bus Anschluss" für ein zweites Türblatt einer zweiflügeligen Tür umfassen. Zusätzlich oder alternativ können dieselben Türkomponententypen zur Installation an mehreren, insbesondere hintereinanderliegenden, Türen vorgesehen sein.

Es ist denkbar, dass das Türsystem ein erstes Bussystem umfasst. Das erste Bussystem kann z.B. als ein CAN-Bus ausgebildet sein. Es kann sein, dass mehrere Türkomponenten des Türsystems mit dem ersten Bussystem verbunden sind. Das erste Bussystem ist als Kommunikationsbus ausgestaltet und/oder dient zur Übermittlung von Nachrichten.

Erfindungsgemäß sind die Türsystemtypen vorkonfiguriert. Durch das zur Verfügung Stellen von vorkonfigurierter Türsystemtypen mit mehreren Türkomponententypen kann insbesondere verhindert werden, dass nicht zusammenpassende oder für die Einbausituation und/oder den Zweck der Tür geeignete Türkomponenten zur Installation ausgewählt werden, die gemeinsam ein Sicherheitsrisiko darstellen. Somit kann durch das erfindungsgemäße Verfahren die Installation aus sicherheitstechnischen Aspekten verbessert werden.

Ein wesentlicher Aspekt ist, dass vorkonfigurierte technische Daten des ausgewähltem Türsystemtyps dem Installateur zur Verfügung gestellt werden. Anhand der vorkonfigurierten technischen Daten kann der Installateur die Installation vornehmen. Dadurch, dass zu den verschiedenen Türsystemtypen jeweils vorkonfigurierte, zu dem jeweiligen Türsystemtyp passende Daten zur Verfügung stehen, kann das Risiko verringert werden, dass die Installation fehlerhaft verläuft und damit die Sicherheit des installierten Türsystems verringert ist.

Durch eine Benutzervorgabe ist erfindungsgemäß zumindest ein Türsystemtyp durch das Konfigurationssystem vorselektierbar. Die Benutzervorgabe kann hierbei zumindest eine technische Benutzervorgabe umfassen. Eine technische Benutzervorgabe kann eine technische Anforderung an den auszuwählenden Türsystemtyp umfassen. Beispiele für eine technische Anforderung sind z. B. "mit einem motorischen Drehflügeltürantrieb", "mit einem motorischen Türantrieb für eine Gewichtsklasse einer Tür", "mit einem Einsteckmotorschloss", "mit einer Authentifizierungsvorrichtung", oder spezifischer "mit einem Kartenleser". Zusätzlich oder alternativ kann die Benutzervorgabe eine funktionelle Anforderung an den auszuwählenden Türsystemtyp umfassen. Beispielsweise kann eine funktionelle Anforderung z. B. "barrierefrei", "für eine Brandschutztür" oder "für eine Fluchtwegtür" umfassen.

Erfindungsgemäß werden nur diejenigen Türsystemtypen dem Benutzer zur Auswahl zur Verfügung gestellt, die der Benutzervorgabe entsprechen. Benutzervorgaben wirken somit im Sinne der Erfindung als Filter, aus denen der Benutzer auswählen kann. Hierdurch kann die Sicherheit des Türsystems für den Betrieb sichergestellt werden. Somit kann insbesondere sichergestellt werden, dass ein Sicherheitsrisiko für Menschen im Gefahrenfalle verringert wird, indem nur die passenden Türsystemtypen und damit indirekt die passenden Daten für die Türsysteme zur Auswahl bereitgestellt werden. Zusätzlich oder alternativ kann die Sicherheit dadurch gewährleistet werden, dass, indem nur die passenden Türsystemtypen und damit indirekt die korrekten passenden Daten für die Türsysteme zur Auswahl bereitgestellt werden, ein Einbruch- oder Manipulationsschutz erhöht ist.

Bevorzugt sind in der Datenbank die Benutzervorgaben mit den Türsystemtypen verknüpft. Somit sind jedem Türsystemtyp zumindest eine mögliche funktionale und/oder technische Benutzervorgabe fest zugeordnet. Die Datenbank kann einer ersten Datenbank entsprechen. Das Konfigurationssystem kann die Datenbank umfassen. Alternativ kann die Datenbank extern des elektronischen Konfigurationssystems vorgesehen sein.

Die erste Datenbank und/oder eine zweite Datenbank kann die dem Türsystemtyp zugeordneten technischen Daten umfassen. In der ersten und/oder zweiten Datenbank ist jeweils ein Türsystemtyp mit den dem Türsystemtyp zugeordneten Daten verknüpft.

Bevorzugt ist vorgesehen, dass die festgelegte Türkomponententypen eines Türsystems vorkonfiguriert sind. d. h. die Daten des Türkomponententyps kann bereits zumindest einen vorgegebenen Parameter umfassen, wie z. B. eine Öffnungsgeschwindigkeit.

Bevorzugt ist eine Recheneinheit vorgesehen. Die Recheneinheit kann das Konfigurationssystem umfassen. Die Recheneinheit kann die erste Datenbank umfassen. Die Recheneinheit kann die zweite Datenbank umfassen. Die Recheneinheit kann zumindest einen elektronischen Speicher zum Speichern der ersten und/oder zweiten Datenbank umfassen. Die Recheneinheit kann zumindest einen Prozessor umfassen. Die Recheneinheit kann eine Anzeigevorrichtung umfassen, um dem Benutzer die vorselektierten Türsystemtypen zur Auswahl bereitzustellen. Alternativ kann die Recheneinheit mit einer Anzeigevorrichtung informationstechnisch verbindbar sein, um dem Benutzer die vorselektierten Türsystemtypen zur Auswahl bereitszustellen. Die Recheneinheit kann eine Eingabevorrichtung, z. B. eine Tastatur und/oder einen berührungssensitiven Bildschirm umfassen, und/oder mit einer Eingabevorrichtung informationstechnisch verbunden sein, damit der Benutzer die Auswahl vornehmen kann.

Die Recheneinheit kann z. B. als eine Cloud und/oder als eine Cloud und einen mit der Cloud verbundenen Rechengerät, z. B. einem Personal Computer, ausgebildet sein. Die Recheneinheit kann mit einem mobilen Endgerät, z. B. einem Mobiltelefon oder einem Tablet, verbunden oder verbindbar sein. Hierbei können die Recheneinheit und das mobile Endgerät beispielsweise über eine Telekommunikationsverbindung und/oder über das Internet miteinander verbindbar sein.

Das Zugangssystem kann die Recheneinheit und/oder das mobile Endgerät umfassen. Das Zugangssystem kann das zu installierende Türsystem umfassen.

Bei dem erfindungsgemäßen Verfahren handelt es sich bevorzugt um ein computerimplementiertes Verfahren. Bei dem computerimplementierten Verfahren ist die Eingabe des Benutzers zur Erfassung der technischen und/oder funktionalen Benutzervorgabe notwendig.

Insbesondere kann vor Schritt a. vorgesehen sein, dass mehrere Türsystemtypen durch einen Benutzer vorkonfiguriert werden, indem zu jedem Türsystemtyp mehrere Türkomponententypen zugeordnet hinterlegt worden sind und/oder indem Daten des Türsystemtyps erstellt worden sind und als dem Türsystemtyp zugeordnet hinterlegt worden sind. Dem Türsystemtyp ist zumindest eine technische und/oder funktionelle Benutzervorgabe zugeordnet in der Datenbank, insbesondere in der ersten Datenbank, hinterlegt worden.

Anders ausgedrückt, werden durch den Benutzer einem Türsystemtyp mehrere Türkomponententypen zugeordnet. Zudem werden durch den Benutzer dem Türsystemtyp zumindest eine funktionelle und/oder technische Benutzervorgabe zugeordnet. Insbesondere wird diese Zuordnung in der ersten Datenbank hinterlegt. Ebenfalls werden die Türkomponententypen des Türsystemtyps in der ersten Datenbank hinterlegt. Zu dem so erstellten Türsystemtyp werden technischen Daten durch den Benutzer erstellt. Die technischen Daten werden dem jeweiligen Türsystemtyp zugeordnet ebenfalls in einer Datenbank, in der ersten Datenbank und/oder in der zweiten Datenbank, hinterlegt.

Somit kann das Verfahren auf eine elektronisch hinterlegte Verknüpfung der technischen und/oder funktionellen Benutzervorgabe mit dem Türsystemtyp der ersten Datenbank und/oder einer elektronisch hinterlegten Verknüpfung der Daten mit dem Türsystemtyp einer Datenbank, insbesondere der ersten oder der zweiten Datenbank, basieren.

Insbesondere kann vorgesehen sein, dass, wenn das Konfigurationssystem keinen für den auszuwählenden Benutzer passendes Türsystemtyp in Schritt a. bereitgestellt hat, einem erstellenden Benutzer, der einen neuen Türsystemtyp zu erstellen hat, eine bereits erfolgte Benutzervorgabe elektronisch über das Konfigurationssystem mitgeteilt wird. Zusätzlich oder alternativ kann es vorgesehen sein, dass dem erstellenden Benutzer anhand der Benutzervorgabe zumindest ein ähnlicher Türsystemtyp von dem Konfigurationssystem vorgeschlagen wird, um eine Hilfestellung bei der Erstellung eines neuen Türsystemtyps zu geben. Zweckmäßig ist dabei, wenn das Konfigurationssystem das Vorkonfigurieren eines neuen Türsystemtyps elektronisch anfordert. Wenn beispielsweise durch das Konfigurationssystem festgestellt wird, dass ein bestimmtes Motorschloss, das einen eigenen Türkomponententyp bildet, in keinem oder keinem geeigneten Türsystemtypen angeordnet ist, wird ein neuer Türsystemtyp angefordert.

Insbesondere kann vorgesehen sein, dass ein digitaler Bauplan in das elektronische Konfigurationssystem eingelesen wird. Der digitale Bauplan kann insbesondere vor Schritt a. in das elektronische Konfigurationssystem eingelesen werden. Bei dem digitalen Bauplan kann es sich um einen zweidimensionalen Bauplan oder um ein dreidimensionales Computermodell handeln.

Es kann sein, dass mit der Auswahl eines Türsystemtyps für einen Installationsort das zu installierende Türsystem mit einer Kennzeichnung, insbesondere einer einmaligen Kennzeichnung, versehen wird.

Es ist denkbar, dass, nachdem der Türsystemtyps durch den Benutzer in Schritt a. ausgewählt wurde, der vorkonfigurierte, ausgewählte Türsystemtyp in dem digitalen Bauplan an dem vorgesehenen Installationsort platziert, insbesondere eingefügt oder verlinkt, wird. Zusätzlich oder alternativ kann das zu installierende Türsystem mit der Kennzeichnung versehen werden, die dem Installationsort zugeordnet wird. Die Kennzeichnung kann insbesondere auf dem digitalen Bauplan platziert, insbesondere eingefügt oder verlinkt, werden.

Insbesondere kann es sein, dass eine Zuordnung eines Türsystemtyps und/oder der Kennzeichnung an einem Installationsort im Bauplan gespeichert und bei einer Änderung des Türsystemtyps und/oder der Kennzeichnung an dem Installationsort die ursprüngliche Zuordnung archiviert wird.

Es ist denkbar, dass der digitale Bauplan durch den Benutzer in dem Konfigurationssystem in mehrere insbesondere sichtbare Sicherheitsbereiche unterteilbar ist. Die Sicherheitsbereiche können dabei z. B. Bereiche mit denselben Zutrittsanforderungen umfassen. Die Sicherheitsbereiche können dabei z. B. Bereiche mit denselben Gefahrensicherheitsanforderungen umfassen. Beispielsweise können die Sicherheitsbereiche farbig markiert sein.

Insbesondere kann vorgesehen sein, dass anhand des Sicherheitsbereichs das Bereitstellen in Schritt a. auf zu dem Sicherheitsbereich passende Türsystemtypen reduziert ist. Alternativ oder zusätzlich kann in Schritt a. die Benutzervorgabe den Sicherheitsbereich umfassen. Es ist denkbar, dass das Konfigurationssystem bei der Auswahl eines zu dem Sicherheitsbereich unpassenden Türsystemtyps warnt.

Bevorzugt kann sein, dass, wenn die Benutzereingabe den Einsatz für einen Gefahrenfall umfasst, in Schritt a. ausschließlich der zumindest eine Türsystemtyp zur Auswahl bereitgestellt wird, der eine Vorgabe für den Gefahrenfall, die dem Schutz von Menschenleben dient, am Installationsort erfüllt. Damit ist vorteilhaft auch normierten Vorgaben zur Installation Rechnung getragen. Der Einsatz für einen Gefahrenfall kann z. B. den Einsatz zur Bereitstellung eines Fluchtwegs und/oder eines Brandschutzes entsprechen.

Bevorzugt kann vorgesehen sein, dass nach Schritt a. die ausgewählten Türsystemtypen verschiedenen Installationsorten zugeordnet sind. Es ist denkbar, dass das Konfigurationssystem elektronisch überprüft, ob die ausgewählten Türsystemtypen zu dem Installationsort konsistent sind und/oder zu Türsystemtypen, die auf einer begehbaren Route auf dem Bauplan liegen, konsistent sind.

Wenn beispielsweise an einem Gang zwei Fluchtwegtypen ausgewählt werden, wobei der dritte Fluchtwegtyp aber keine Fluchtwegtür ist, wird die Inkonsistenz angezeigt, so dass frühzeitig korrigiert werden kann. Wenn beispielsweise an allen Außentüren Zutrittsberechtigungsvorrichtungen ausgewählt sind, nur an einer nicht, wird die Inkonsistenz angezeigt, so dass frühzeitig korrigiert werden kann. Wenn beispielsweise alle Gänge im Krankenhaus, durch die Betten geschoben werden, einen Türantrieb haben, nur eine Tür nicht, wird die Inkonsistenz angezeigt, so dass frühzeitig korrigiert werden kann. Hierzu können in dem Konfigurationssystem auf dem digitalen Bauplan verschiedene Wege und/oder Sicherheitsbereiche markiert werden.

Bevorzugt kann vorgesehen sein, dass derselbe Türsystemtyp von dem Konfigurationssystem automatisch für weitere Türen eines räumlichen Bereichs, z. B. eines Sicherheitsbereichs, in Schritt a. bereitgestellt wird. Insbesondere kann vorgesehen sein, dass die Art der Bereitstellung dem auswählenden Benutzer anzeigt, dass der Türsystemtyp bereits verwendet worden ist. Zweckmäßig ist dabei, dass das Konfigurationssystem bereits einmal verwendete Türsystemtypen speichert. Die Speicherung als "einmal verwendet" kann sich z. B. auf einen digitalen Bauplan, eine digitale Bauplangruppe, ein Gebäude und/oder einen Benutzer beziehen. Das Konfigurationssystem schlägt insbesondere die bereits einmal verwendeten Türsystemtypen als bevorzugt erneut vor. Hierdurch kann beispielsweise eine Favoritenleiste erstellt werden. Zusätzlich oder alternativ kann vorgesehen sein, dass die bereits verwendete Türsystemtypen markiert werden. Diese Maßnahmen sind vorteilhaft hinsichtlich einer weniger fehleranfälligen Installation.

Es ist denkbar, dass für einen Benutzer oder eine Benutzergruppe eine reduzierte Anzahl von Türsystemtypen zur Vorselektion durch das Konfigurationssystem zur Verfügung steht. Insbesondere können Untergruppen von Türsystemtypen für einzelne Benutzer, Benutzergruppen, digitale Baupläne, digitale Bauplangruppen und/oder Gebäude konfigurierbar sein. Auch diese Maßnahmen sind vorteilhaft hinsichtlich einer weniger fehleranfälligen Installation.

Bevorzugt kann vorgesehen sein, dass das elektronische Konfigurationssystem mehrere Berechtigungsstufen umfasst, wobei jedem Benutzer eine Berechtigungsstufe zugeordnet ist, wobei zumindest zwei, bevorzugt alle, der folgenden Berechtigungsstufen vorgesehen sind:
- eine erste Berechtigungsstufe, die das Erstellen eines neuen Türsystemtyps erlaubt,
- eine zweite Berechtigungsstufe, die die Auswahl eines vorkonfigurierten Türsystemtyps und/oder das Einstellen von Benutzervorgaben erlaubt,
- eine dritte Berechtigungsstufe, die das Abrufen oder Einsehen von Daten des ausgewählten Türsystemtyps erlaubt.

Bevorzugt ist für Benutzer der zweiten Berechtigungsstufe verboten, einen neuen Türsystemtyp zu erstellen. Bevorzugt ist für Benutzer der dritten Berechtigungsstufe verboten, einen Türsystemtyps auszuwählen oder Benutzervorgaben einzustellen. Bevorzugt ist für Benutzer der dritten Berechtigungsstufe verboten, einen neuen Türsystemtyp zu erstellen.

Bevorzugt ist es für Benutzer der ersten Berechtigungsstufe erlaubt, einen vorkonfigurierten Türsystemtyp auszuwählen und/oder Benutzervorgaben einzustellen. Bevorzugt ist es für Benutzer der ersten Berechtigungsstufe erlaubt, die technischen Daten des ausgewählten Türsystemtyps abzurufen. Bevorzugt ist es für Benutzer der zweiten Berechtigungsstufe erlaubt, die technischen Daten des ausgewählten Türsystemtyps abzurufen. Unter Einsehen kann z. B. das Öffnen einer Datei auf der Recheneinheit verstanden werden. Unter Abrufen kann z. B. ein Download oder das Anfordern einer Zusendung verstanden werden. Somit hat der Benutzer der ersten Berechtigungsstufe mehr Rechte als der Benutzer der zweiten Berechtigungsstufe. Ein Benutzer der dritten Berechtigungsstufe hat weniger Rechte als ein Benutzer der ersten und/oder zweiten Berechtigungsstufe.

Es ist denkbar, dass in dem Konfigurationssystem nur die erste und die zweite Berechtigungsstufe vorgesehen sind. Dieses ist insbesondere denkbar, wenn derjenige Benutzer, der die Auswahl aus den Türsystemtypen trifft, auch die Installation vor Ort vornimmt. Alternativ können in dem Konfigurationssystem nur die zweite und die dritte Berechtigungsstufe vorgesehen sein. Dieses ist insbesondere denkbar, wenn keine neuen Türsystemtypen erstellt werden sollen. Es ist denkbar, dass in dem Konfigurationssystem nur die erste und die dritte Berechtigungsstufe vorgesehen sind. Dieses ist insbesondere denkbar, wenn die Auswahl der Türsystemtypen häufig mit einer Erstellung eines neuen Türsystemtyps einhergeht. In einer besonders bevorzugten Variante umfasst das Konfigurationssystem die erste, die zweite und die dritte Berechtigungsstufe.

Durch die abgestuften Befugnisse einzelner Benutzer kann die Sicherheit bei der Installation gewährleistet sein. So benötigt es herausragende Fachkenntnisse, um einen neuen Türsystemtyp zu erstellen. Es benötigt hohe Fachkenntnisse, den richtigen Türsystemtyp für einzelne Installationsorte auszuwählen. Durch das zur Verfügung Stellen der Daten für den Türsystemtyp ist es hingegen bevorzugt nicht notwendig, dass vor Ort bei der Installation herausragende oder hohe Fachkenntnisse zur Verfügung stehen. Vielmehr reichen bevorzugt allgemeine Installationskenntnisse aus anderen Gebieten aus, um das Türsystem vor Ort zu installieren. Bei dem Benutzer der dritten Berechtigungsstufe handelt es sich insbesondere um den Installateur vor Ort.

Vorzugsweise sind die von einem Benutzer vorkonfigurierten mehrere Türsystemtypen, die vor Schritt a. hinterlegt worden sind, von einem Benutzer der ersten Berechtigungsstufe hinterlegt worden. Es ist ebenfalls denkbar, dass es sich bei einem erstellenden Benutzer, der einen neuen Türsystemtyp zu erstellen hat und dem eine bereits erfolgte Benutzervorgabe elektronisch über das Konfigurationssystem mitgeteilt wird und/oder anhand der Benutzervorgabe zumindest ein ähnlicher Türsystemtyp von dem Konfigurationssystem vorgeschlagen wird, einem Benutzer der ersten Berechtigungsstufe handelt.

Es ist denkbar, dass die Berechtigungsstufen in dem elektronischen Konfigurationssystem festgelegt sind. Es kann sein, dass die Berechtigungsstufen mit einem Benutzer, insbesondere einer Authentifizierung des Benutzers verknüpft sind. Beispielsweise muss ein Benutzer einen Benutzernamen und/oder ein Passwort eingeben oder sich durch ein biometrisches Merkmal authentifizieren, um mit dem Konfigurationssystem zu arbeiten. In dem Konfigurationssystem ist der Benutzername, das Passwort und/oder das biometrische Merkmal mit der Berechtigungsstufe verknüpft.

Insbesondere kann vorgesehen sein, dass, insbesondere in der dritten Berechtigungsstufe, Detailinformationen in einer Datenbank, insbesondere in einer dritten Datenbank, zu dem ausgewählten Türsystemtyp oder dem zu installierenden Türsystem hinzufügbar sind. Beispielsweise können räumliche Ausmaße der zu installierenden Türkomponente, z. B. ein Dornmaß eines Einsteckschlosses, zu dem zu installierenden Türsystem hinzufügbar sein. Hierbei kann z. B. das zu installierende Türsystem anhand der Kennzeichnung aufgerufen werden und die Detailinformation hinzugefügt werden.

Beispielsweise können die Daten für den ausgewählten Türsystemtyp aus der zweiten Datenbank in eine dritte Datenbank überführt werden. In der dritten Datenbank sind die Daten des ausgewählten Türsystemtyps für einen vorgesehenen Installationsort mit Daten des konkret an dem Installationsort zu installierenden Türsystems ergänzt. Es ist denkbar, dass die Recheneinheit die dritte Datenbank umfasst.

Bevorzugt umfasst die Detailinformation zumindest ein räumliches Ausmaß. Bevorzugt hingegen kann die Detailinformation frei sein von der Art und/oder der Anordnung der elektrischen Verbindung und/oder der elektronischen Einbindung der Türkomponenten, der Funktion der Türkomponenten und/oder der funktionellen Eigenschaften der Türkomponenten. Die Art und/oder die Anordnung der elektrischen Verbindung und/oder die elektronische Einbindung der Türkomponenten, die Funktion der Türkomponenten und/oder die funktionellen Eigenschaften der Türkomponenten sind bevorzugt inhärente Eigenschaften des ausgewählten Türsystemtyps.

Bevorzugt kann vorgesehen sein, dass die vorkonfigurierten technischen Daten, die in Schritt b. zur Verfügung gestellt werden, mit dem Türsystemtyp verknüpft in einer Datenbank, insbesondere in der zweiten Datenbank, hinterlegt sind.

Es ist denkbar, dass die vorkonfigurierten Daten mehrere, insbesondere alle, Türkomponenten des Türsystems betreffen.

Es kann sein, dass die vorkonfigurierten Daten bei einer Eingabe eines Benutzers aus einer Datenbank, insbesondere der zweiten Datenbank und/oder der dritten Datenbank, herunterladbar sind.

Um die technischen Daten aus Schritt b. zur Verfügung zu stellen, kann es sein, dass eine Eingabe des Benutzers, insbesondere des Installateurs, den Türsystemtyp oder eine Angabe, die mit dem Türsystemtyp verknüpft ist, insbesondere einen Installationsort oder die Kennzeichnung des Türsystems, beinhaltet.

Diese Maßnahmen sind zweckmäßig bei einem Benutzer der dritten Berechtigungsstufe. Die Datenbank ist insbesondere die zweite Datenbank, in der die technischen Daten und eine Verknüpfung zu einem Türsystemtyp hinterlegt ist. Alternativ kann es sich um die dritte Datenbank handeln, bei der die technischen Daten des Türsystemtyps mit weiteren Daten des zu installierenden Türsystems ergänzt sind.

Bevorzugt kann vorgesehen sein, dass die vorkonfigurierten Daten einen Schaltplan des Türsystems umfassen.

Es ist denkbar, dass der Schaltplan aus dem Konfigurationssystem und/oder aus einer Datenbank auf ein mobiles Endgerät herunterladbar oder einsehbar ist. Bei der Datenbank kann es sich insbesondere um die zweite und/oder die dritte Datenbank handeln. Bei dem mobilen Endgerät kann es sich um ein Mobiltelefon oder ein Tablet handeln.

Um den Schaltplan einzusehen oder abzurufen, insbesondere herunterzuladen, kann vorgesehen sein, dass der Installationsort auf dem digitalen Bauplan, der Türsystemtyp und/oder die Kennzeichnung des Türsystems in das mobile Endgerät eingegeben wird.

Bevorzugt umfasst das Verfahren die räumliche Anordnung der Türkomponenten an den vorgesehenen Positionen. Bevorzugt wird dieses durch den Installateur durchgeführt.

Bevorzugt umfasst das Verfahren das elektrische Verbinden der Türkomponenten gemäß dem Schaltplan. Bevorzugt wird dieses durch den Installateur durchgeführt.

Bevorzugt kann vorgesehen sein, dass die Daten eine elektronische Konfiguration des Türsystems umfassen. Die elektronische Konfiguration kann als zumindest eine elektronische Datei, insbesondere ein Template, ausgebildet sein.

Es kann sein, dass die elektronische Konfiguration zumindest eine, bevorzugt mehrere, besonders bevorzugt alle, der folgenden elektronischen Angaben umfasst:
- Vorgesehene Türkomponententypen des Türsystems
- Sender und/oder Empfänger von Nachrichten innerhalb des Türsystems
- zumindest einen Funktionsablauf des Türsystems, bei dem mehrere Vorgänge in einer vorgegebenen Reihenfolge durchzuführen sind
- Parameter zum Betrieb des Türsystems
- einen Testablauf für das Türsystem, bei dem zur Inbetriebnahme zumindest eine Funktion oder ein Funktionsablauf des Türsystems getestet wird.

Beispielsweise können Türkomponenten des Türsystems informationstechnisch miteinander verbunden sein. Insbesondere können Türkomponenten des Türsystems über ein Bussystem, insbesondere über ein erstes Bussystem, miteinander verbunden sein. Bei dem ersten Bussystem kann es sich beispielsweise um einen CAN-Bus handeln. Die elektronische Konfiguration kann umfassen, welcher Türkomponententyp oder welcher Türkomponententyp an welcher Position welchem anderen Türkomponententyp oder welchem Türkomponententyp an welcher Position eine Nachricht, insbesondere einen Befehl oder eine Information, z. B. eine Statusinformation, sendet.

Es kann sein, dass in dem Türsystem ein zeitlich koordinierter Funktionsablauf des Türsystems vorgesehen sind. Beispielsweise kann zunächst eine Authentifizierung durchgeführt werden, um anschließend einen Zutritt für den Anwender zu ermöglichen. Hierzu kann ein Verriegelungselement oder ein Türöffner nach erfolgreicher Authentifizierung angesteuert werden. In einem anderen Beispiel wird zunächst die Tür entriegelt, um die Tür danach motorisch aufzufahren. Ein anderes Beispiel ist die motorische Öffnung einer Gangflügeltür vor einer Standflügeltür oder die zeitlich abgestimmte Öffnung der Türen einer Schleuse. Es ist denkbar, dass die elektronische Konfiguration ein Computerprogrammprodukt oder Anweisungen zur Ausführung eines Computerprogrammprodukts umfasst, mittels derer eine Steuerung des Funktionsablaufs ermöglicht ist.

Die elektronische Konfiguration kann Parameter für den Betrieb des Türsystems umfassen. Insbesondere können die Parameter zum Betrieb des Türsystems Parameter für die einzelnen Türkomponenten umfassen. Beispiele für Parameter können eine Öffnungs- und/oder Schließgeschwindigkeit eines Türantriebs, eine Offenhaltezeit des Türantriebs, eine Entriegelungszeit eines Verriegelungselements, eine Überwachungszeit, bevor ein Alarm ausgegeben wird, umfassen.

Es ist bevorzugt vorgesehen, dass die elektronische Konfiguration einen Testablauf für das Türsystem oder Anweisungen zur Ausführung des Testablaufs umfasst. Bei der Installation wird insbesondere der zumindest eine Funktionsablauf getestet. Somit kann das erfindungsgemäße Verfahren die Durchführung des Testablaufs umfassen.

Das Türsystem kann ein Steuergerät als eine Türkomponente umfassen. Das Steuergerät ist insbesondere mit weiteren Türkomponenten informationstechnisch verbunden. Somit können das Steuergerät und die weitere Türkomponente Nachrichten austauschen. Das Steuergerät ist insbesondere mit der Recheneinheit informationstechnisch verbunden. Das Steuergerät kann mit dem ersten Bussystem verbunden sein. Das Steuergerät kann mit einem zweiten Bussystem verbunden sein. Insbesondere handelt es sich bei dem zweiten Bussystem um einen IP-fähigen Bus, wie z. B. LON, LAN oder das Ethernet. Insbesondere sind die Recheneinheit und das Steuergerät über das zweite Bussystem miteinander verbunden.

Das Steuergerät kann eine Sende- und Empfangseinheit zur kabellosen Nahbereichskommunikation, insbesondere Bluetooth Low Energy, mit dem mobilen Endgerät umfassen.

Insbesondere kann die elektronische Konfiguration über eine informationstechnische Verbindung, z.B. ein Bussystem, insbesondere das zweiten Bussystems, oder über das mobile Endgerät in das Türsystem, insbesondere in das Steuergerät, geladen werden.

Bevorzugt kann vorgesehen sein, dass die elektronische Konfiguration des Türsystems in dem Steuergerät gespeichert wird.

Es ist denkbar, dass das Türsystem zumindest eine Türkomponente, bevorzugt mehrere Türkomponenten umfasst, wobei die zumindest eine Türkomponente zu zumindest einer Türkomponentengruppe, bevorzugt zu mehreren der folgenden Türkomponentengruppen gehören:
- motorischer Türantrieb
- Verriegelungselement,
- Signalgeber zum Öffnen, Anhalten, Schließen, Verriegeln oder Entriegeln einer Tür, insbesondere einen Sensor, eine Authentifizierungsvorrichtung oder einen Gefahrenmelder,
- Erfassungseinheit zum Empfang eines Zutrittsattributs

Bei dem motorischen Türantrieb kann es sich insbesondere um einen. Schiebetürantrieb, Drehflügeltürantrieb und/oder Karusselltürantrieb handeln. Bei dem Verriegelungselement kann es insbesondere ein Element handeln, mit dem eine Tür elektrisch verriegelt und/oder entriegelt werden kann. Beispiele sind z.B. eine Antriebsverriegelung, ein Motorschloss, eine elektro-magnetisches Türverriegelung.

Das Türsystem kann eine Vorrichtung zur Ermöglichung einer manuellen Entriegelung der Tür umfassen. Beispielsweise kann das Türsystem einen Türöffner, einen elektromechanischen Schließzylinder oder einen elektromechanischen Beschlag umfassen.

Das Türsystem kann einen Signalgeber, insbesondere einen Sensor, eine Authentifizierungsvorrichtung, eine Fluchtwegsteuerung oder einen Gefahrenmelder, umfassen. Bevorzugt erzeugt der Signalgeber eine Nachricht, insbesondere ein Bustelegramm, als Signal. Bevorzugt ist der Signalgeber mit einem Bussystem, insbesondere dem ersten Bussystem verbunden.

Das Türsystem kann ausgebildet sein, ein Zutrittsattribut eines berechtigten Benutzers zu empfangen. Hierzu kann das Türsystem eine Erfassungseinheit umfassen. Die Erfassungseinheit kann als eine Sende- und Empfangseinheit, als ein biometrischer Sensor, als ein Tastenfeld zur PIN-Eingabe und/oder als ein Kontaktelement zur elektrischen Kontaktierung eines insbesondere elektronischen Schlüssels ausgebildet sein. Das Zutrittsattribut kann als ein Credential oder als ein biometrisches Merkmal des Benutzers ausgebildet sein. Das Credential kann z. B. einen Zugangscode und/oder ein Zeitfenster für eine Zutrittsberechtigung umfassen. Es kann sein, dass das Türsystem z. B. einen Leser mit einer Sende- und Empfangseinheit zum kabellosen Empfang eines Zutrittsattributs, insbesondere Credentials, ausgebildet ist. Die Sende- und Empfangseinheit kann ausgebildet sein, mit einem mobilen Endgerät, insbesondere einem Mobiltelefon oder einer Karte, durch Nahbereichskommunikation, insbesondere RFID, NFC oder Bluetooth Low Energy, zu kommunizieren.

Bevorzugt ist vorgesehen, dass Türkomponenten aus der Gruppe der Türantriebe, Verriegelungselemente und Signalgeber untereinander informationstechnisch, bevorzugt über ein Bussystem, besonders bevorzugt über das erste Bussystem, miteinander verbunden sind.

Bevorzugt ist vorgesehen, dass Türkomponenten aus der Gruppe der Erfassungseinheiten untereinander informationstechnisch, bevorzugt über ein Bussystem, miteinander verbunden. Es kann sein, dass das Türsystem einen weiteres Bussystem umfasst. Das weitere Bussystem, z. B. ein RS485 Bus, kann dazu dienen, zumindest eine Erfassungseinheit mit dem Steuergerät und/oder mehrere Erfassungseinheiten untereinander zu verbinden. Alternativ kann eine serielle Schnittstelle, z. B. RS232, verwendet werden, um eine Türkomponente, insbesondere eine Erfassungseinheit, mit dem Steuergerät zu verbinden.

Es kann sein, dass in derselben Türkomponente mehrere Funktionen verwirklicht sind. Beispielsweise kann ein elektromechanischer Beschlag ein Kupplungselement umfassen, das in einem eingekuppelten Zustand das manuelle Entriegeln der Tür erlaubt. Zugleich umfasst der elektromechanische Beschlag eine Erfassungseinheit, insbesondere eine Sende- und Empfangseinheit zum kabellosen Empfang eines Credentials. Zudem kann der elektromechanische Beschlag einen Prozessor und einen Speicher umfassen, mit dem das Credential ausgewertet und über den Zutritt entschieden wird. Somit wirkt der elektromechanische Beschlag als eine Authentifizierungsvorrichtung.

Es kann sein, dass mehrere Türkomponenten mit dem ersten Bussystem verbunden sind. Beispielsweise kann zumindest ein Türantrieb und zumindest ein Verriegelungselement mit dem ersten Bussystem verbunden sein. Zudem kann das Steuergerät mit dem ersten Bussystem verbunden sein.

Insbesondere kann das Türsystem eine Fluchtwegsicherung mit einem Nottaster und einer Türverriegelung umfassen.

Bevorzugt kann sein, wenn das Zugangssystem, bevorzugt das Türsystem, besonders bevorzugt das Steuergerät, Kenntnis von in dem Türsystem tatsächlich verbauten Türkomponenten hat und mit den vorgesehenen Türkomponententypen des Türsystemtyps in der elektronischen Konfiguration vergleicht, wobei bei einer Abweichung der verbauten Türkomponenten mit den vorgesehenen Türkomponententypen elektronisch hinterlegt vordefiniert ist, wie das Installationsverfahren weiterzuführen ist. Hierbei kann das Steuergerät zumindest Kenntnis von den im Türsystem verbauten Türkomponenten haben, die informationstechnisch, insbesondere über ein Bussystem, mit dem Steuergerät verbunden sind.

Insbesondere wird elektronisch erkannt, wenn eine höherwertige Komponente verbaut ist, als vorgesehen ist. In einem solchen Fall kann das Installationsverfahren weitergeführt werden.

Das Installationsverfahren kann zusätzlich oder alternativ weitergeführt werden, wenn tolerierbare Abweichungen von dem Zugangssystem, insbesondere dem Steuergerät, erkannt werden. Tolerierbare Abweichungen können z.B. räumliche Ausmaße sein.

Insbesondere kann vorgesehen sein, dass die Vordefinition, wie das Installationsverfahren weiterzuführen ist, in Abhängigkeit von der Art der Abweichung eine der folgenden Optionen entspricht:
- die Aufnahme eines Betriebs des Türsystems ist elektronisch verhindert,
- die Aufnahme eines Betriebs des Türsystems erfolgt mit einem eingeschränktem Türkomponentenumfang,
- die Aufnahme eines Betriebs des Türsystems erfolgt wie vorgesehen.

Insbesondere werden dem Benutzer automatisch die Abweichung mitgeteilt. Es ist denkbar, dass dem Benutzer die vordefinierte Weiterführung dem Benutzer vorgeschlagen wird. In einer Alternative wird die vordefinierte Weiterführung automatisch durchgeführt.

Besonders bevorzugt ist vorgesehen, dass eine Abweichung der verbauten Türkomponenten von den vorgesehenen Türkomponententypen des ausgewählten Türsystemtyps immer oder zumindest überwiegend zu einem Abbruch des Installationsverfahrens mit dem ausgewählten Türsystemtyp und/oder der verwendeten elektronischen Konfiguration führt. Ein solcher Abbruch ist insbesondere vorgesehen, wenn die Abweichung in der Art und/oder die Anordnung der elektrischen Verbindung und/oder die elektronische Einbindung der Türkomponenten, die Funktion der Türkomponenten und/oder die funktionellen Eigenschaften der Türkomponenten umfasst.

Bevorzugt kann vorgesehen sein, dass bei einer definierten Abweichung die Aufnahme eines Betriebs des Türsystems elektronisch verhindert ist. Eine solche Verhinderung tritt insbesondere dann ein, wenn die Art und/oder die Anordnung der elektrischen Verbindung und/oder die elektronische Einbindung der Türkomponenten, die Funktion der Türkomponenten und/oder die funktionellen Eigenschaften der Türkomponenten nicht den vorgesehenen Türkomponententypen entspricht.

Es ist denkbar, dass die verbauten Türkomponenten als Teil des alternativen Türsystemtyps mit der elektronischen Konfiguration eines alternativen Türsystemtyps installiert werden.

Bei Vorliegen der definierten Abweichung wird insbesondere die Verwendung eines alternativen Türsystemtyps, das den tatsächlich verbauten Türkomponententypen entspricht, in dem Konfigurationssystem geprüft.

Insbesondere kann vorgesehen sein, dass der alternative Türsystemtyp zur Auswahl durch den Benutzer, insbesondere einem Benutzer der ersten oder zweiten Berechtigungsstufe, vorgeschlagen wird, bevor die Installation mit der elektronischen Konfiguration des alternativen Türsystemtyps installiert wird. Hierdurch kann der Benutzer Inkonsistenzen sehen und korrigieren.

Bevorzugt kann sein, wenn das Steuergerät Kenntnis von der in dem Türsystem tatsächliche verbauten Türkomponententypen hat, indem die Türkomponenten sich bei dem Steuergerät unter Angabe des Türkomponententyps anmelden. Es kann sein, dass die Anmeldung über das erste Bussystem erfolgt.

Insbesondere kann vorgesehen sein, dass das Türsystem einen Adapter umfasst, wobei der Adapter ausgebildet ist, für eine nicht selbstständig mit den übrigen Türkomponenten kommunikationsfähige Türkomponente mit den übrigen Türkomponenten zu kommunizieren, insbesondere wobei der Adapter mit dem Bussystem verbunden ist.

Bevorzugt kann vorgesehen sein, wenn in dem Zugangssystem, insbesondere in der Recheneinheit, eine Kennzeichnung der verbauten Türkomponente zusammen mit zumindest einem weiteren Merkmal der Komponente, insbesondere dem Türkomponententyp, hinterlegt ist. Die Hinterlegung kann beispielsweise vor Schritt a. erfolgen. Die Hinterlegung kann in einer Datenbank, insbesondere in der dritten Datenbank, erfolgen. Die Hinterlegung kann beispielsweise im Rahmen der Herstellung der Türkomponente erfolgen. Das weitere Merkmal kann beispielsweise eine Information über den Produktionsort und/oder die Produktionszeit umfassen. Bei der Kennzeichnung kann es sich um eine einmalig verwendete Kennzeichnung handeln. Bei der Kennzeichnung kann es sich um eine einmalig in der dritten Datenbank verwendete Kennzeichnung handeln.

Es ist denkbar, dass am Ende der Installation die Kennzeichnung von verbauten Türkomponenten einer Kennzeichnung des Türsystems und/oder dem Installationsort zugeordnet und in der Recheneinheit hinterlegt ist. Insbesondere kann die Kennzeichnung in der Recheneinheit gespeichert sein, wobei als weiteres Merkmal auch ein Produktionsort und -datum speicherbar ist. Hierdurch lässt sich nachvollziehen, welche Türkomponente wo verbaut worden ist. Die Zuordnung erfolgt zumindest für diejenigen Türkomponenten, die mit dem Steuergerät informationstechnisch, insbesondere über ein Bussystem, verbunden sind. Besonders bevorzugt erfolgt die Zuordnung für alle Türkomponenten des Türsystems.

In einem weiteren Aspekt der Erfindung wird ein Computerprogrammprodukt zur Durchführung des Verfahrens aufgezeigt. Mit dem Computerprogrammprodukt sind die oben mit Bezug auf die entsprechende Ausgestaltung des Verfahrens genannten Vorteile entsprechend verbunden. Insbesondere kann das entsprechend ausgebildete Computerprogrammprodukt zur Durchführung des Verfahrens verwendet werden. Das Computerprogramm kann Befehle zur Durchführung des erfindungsgemäßen Verfahrens umfassen. Das Computerprogrammprodukt kann das Konfigurationssystem umfassen. Das Computerprogrammprodukt kann auf der Recheneinheit ausführbar gespeichert sein. Ein weiteres Computerprogrammprodukt zur Ausführung eines bevorzugten Verfahrens kann in dem Türsystem, insbesondere in dem Steuergerät, ausführbar gespeichert sein. Das auf dem Steuergerät gespeicherte Computerprogrammprodukt kann Befehle zum Durchführen eines vorteilhaften Verfahrens, insbesondere eines Verfahrens nach einem der Ansprüche 10 bis 12 umfassen.

In einem weiteren Aspekt der Erfindung wird ein Zugangssystem zur Durchführung des Verfahrens angegeben. Mit dem Zugangssystem sind die oben mit Bezug auf die entsprechende Ausgestaltung des Verfahrens genannten Vorteile entsprechend verbunden. Insbesondere kann das entsprechend ausgebildete Zugangssystem zur Durchführung des Verfahrens verwendet werden.

Weitere Einzelheiten und Vorteile der Erfindung sollen nachfolgend anhand des in den Figuren gezeigten Ausführungsbeispiele erläutert werden. Hierbei sind technische Merkmale mit gleicher Funktion in den Figuren mit identischen Bezugszeichen versehen. Hierin zeigt:
- Fig. 1: ein erstes Ausführungsbeispiel einer erfindungsgemäßen Recheneinheit und eines erfindungsgemäßen Zugangssystems,
- Fig. 2: ein zweites Ausführungsbeispiel einer erfindungsgemäßen Recheneinheit und eines erfindungsgemäßen Zugangssystems,
- Fig. 3: eine prinzipielles Ablaufskizze des erfindungsgemäßen Verfahrens.

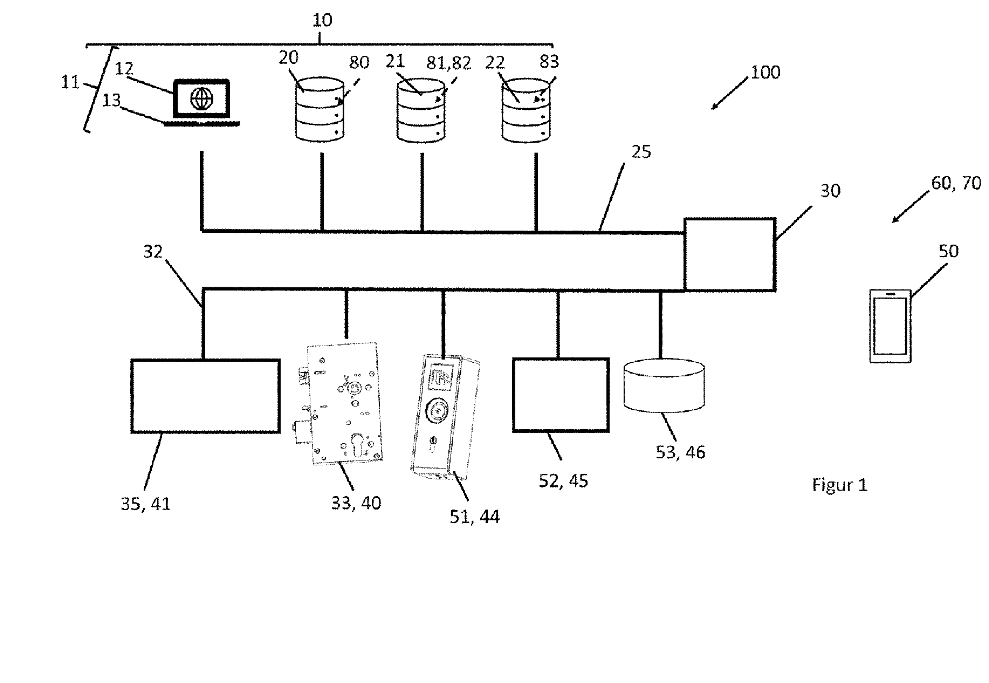

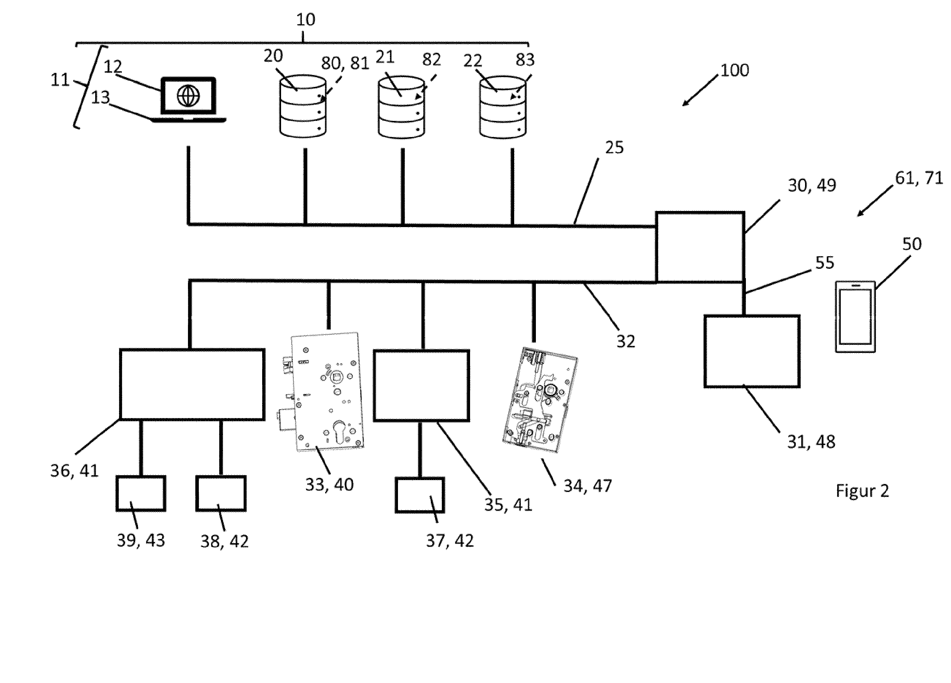

In den Figuren 1 und 2 sind ein erstes Ausführungsbeispiel und ein zweites Ausführungsbeispiel eines erfindungsgemäßen Zugangssystems 100 dargestellt. Das erfindungsgemäße Zugangssystem 100 umfasst eine erfindungsgemäße Recheneinheit 10. Die Recheneinheit 10 umfasst ein Rechengerät 11, das als ein Personal Computer ausgebildet ist. Das Rechengerät 11 umfasst eine Anzeigevorrichtung 12, die als ein Bildschirm ausgebildet ist. Das Rechengerät 11 umfasst eine Eingabevorrichtung 13, die als eine Tastatur ausgebildet ist. Alternativ und nicht dargestellt, kann das Rechengerät z. B. als Tablet ausgebildet sein. Die Eingabevorrichtung 13 kann als ein berührungssensitiver Bildschirm ausgebildet sein.

Die Recheneinheit 10 umfasst des Weiteren zumindest einen elektronischen Speicher. Beispielsweise kann es sich hierbei um einen Speicher einer Cloud handeln. In dem Speicher sind eine erste Datenbank 20, eine zweite Datenbank 21 und eine dritte Datenbank 22 hinterlegt. Alternativ und nicht dargestellt, können die die erste und die zweite Datenbank 20, 21 als eine gemeinsame Datenbank ausgebildet sein. Ebenfalls können die zweite und die dritte Datenbank 21, 22 als eine gemeinsame Datenbank ausgebildet sein. In einer weiteren Alternative können die erste und die dritte Datenbank 20, 22 als eine gemeinsame Datenbank ausgebildet sein. In einer weiteren Datenbank sind die erste bis dritte Datenbank 20, 21, 22 in einer gemeinsamen Datenbank integriert.

In einem elektronischen Speicher der Recheneinheit 10 ist das Konfigurationssystem elektronisch gespeichert. Das Konfigurationssystem ist als Computerprogrammprodukt ausgebildet. Das Konfigurationssystem umfasst die Datenbanken 20, 21, 22.

Zu Beginn des erfindungsgemäßen Installationsverfahrens sind die übrigen in den Figuren 1 und 2 dargestellten Vorrichtungen noch nicht installiert. Vielmehr ist in den Figur 1 und 2 das erfindungsgemäße Zugangssystem 100 an einem möglichen Ende des erfindungsgemäßen Installationsverfahrens 200 dargestellt.

In den Figuren 1 und 2 sind unterschiedliche Türsysteme 60, 61 dargestellt. Die Türsysteme sind Teil des Zugangssystems 100. Die Türsystem 60, 61 umfassen jeweils ein Steuergerät 30 als eine erste Türkomponente. Die Türsysteme 60, 61 umfassen jeweils ein erstes Bussystem 32.

Die Türsysteme 60, 61 umfassen weitere Türkomponenten. Das erste Türsystem 60 in Figur 1 umfasst beispielhaft einen motorischen Türantrieb 35, ein Motorschloss 33, eine Fluchtwegsteuerung 51 mit einem Nottaster, eine elektromagnetische Türverriegelung 52 und einen Gefahrenmelder, insbesondere einen Rauchmelder 53, als weitere Türkomponenten. Die Türkomponenten 35, 33, 51, 52, 53 haben unterschiedliche Funktionen und funktionelle Eigenschaften. Somit gehören die Türkomponenten 33, 35, 51, 52, 53 unterschiedlichen Türkomponententypen 40, 41, 44, 45, 46 an.

Das zweite Türsystem 61 in Figur 2 umfasst mehrere motorische Türantriebe 35, 36 als Türkomponenten. Die motorischen Türantriebe 35, 36 sind identisch ausgebildet und gehören somit demselben Türkomponententypen 41 an. Die Türantriebe 35, 36 sind ausgebildet, jeweils an einem Türflügel einer zweiflügeligen Tür angeordnet zu werden. Des Weiteren umfasst das zweite Türsystem 61 mehrere Sensoren 37, 38 als Türkomponenten. Die Sensoren 37, 38 dienen dazu eine Annäherung einer Person an die Türflügel zu detektieren. Daraufhin können die motorischen Türantriebe 35, 36 die Türflügel in einer zeitlich vorgegebenen Reihenfolge als Funktionsablauf öffnen. Zusätzlich oder alternativ dienen die Signale der Sensoren 37, 38 dazu, die Tür mittels des Türantriebs 35, 36 anzuhalten, um eine Verletzung der Person zu vermeiden. Die Sensoren 37, 38 sind identisch ausgebildet und gehören somit demselben Türkomponententypen 42 an.

Des Weiteren ist ein Programmschalter 39 als Türkomponente vorgesehen. Mittels des Programmschalters 39 ist durch einen Anwender bestimmbar, ob die Sensoren 37, 38 bei der Detektion einer Person eine motorische Türöffnung veranlassen oder nicht. Das zweite Türsystem 61 umfasst ein Motorschloss 34 für einen Gangflügel der zweiflügeligen Tür und ein Motorschloss 33 für einen Standflügel der zweiflügeligen Tür. Der Programmschalter 39 und die Motorschlösser 33, 34 sind jeweils eigenen Türkomponententypen 40, 43, 47 zugeordnet. Eine weitere Türkomponente des zweiten Türsystems 61 ist als Leser 31 ausgebildet. Eine Zutrittsentscheidung wird durch das Steuergerät 30 getroffen. Somit dient das Steuergerät 30 zugleich als Authentifizierungsvorrichtung.

Die Türkomponenten 33, 35, 51, 52, 53 des ersten Türsystems 60 sind mit einem ersten Bussystem 32 verbunden. Einige Türkomponenten 33, 34, 35, 36 des zweiten Türsystems 61 sind mit dem ersten Bussystem 32 verbunden. Andere Türkomponenten 37, 38, 39 des zweiten Türsystems 61 sind nur mittelbar mit dem Steuergerät 30 über einen Türantrieb 35, 36 verbunden. Der Leser 31 ist über ein drittes Bussystem 55 mit dem Steuergerät 30 verbunden. Das Steuergerät 30 umfasst eine Sende- und Empfangseinheit zur kabellosen Nahbereichskommunikation mit einem mobilen Endgerät 50. Das mobile Endgerät 50 ist mit der Recheneinheit 10 informationstechnisch verbindbar, z. B. über ein Telekommunikationsnetz oder über das Internet.

Bei einem weiteren nicht dargestellten Türsystemtyp können mehrere Leser 31 and dem dritten Bussystem 55 vorgesehen sein. Auch können die Sensoren 37, 38 oder der Programmschalter 39 mit dem ersten Bussystem 32 verbunden sein.

Dadurch, dass das erste Türsystem 60 und das zweite Türsystem 61 unterschiedliche Türkomponenten umfasst, entsprechen das erste Türsystem 60 und das zweite Türsystem 61 unterschiedlichen Türsystemtypen 70, 71.

Erfindungsgemäß ist vorgesehen, dass in der ersten Datenbank 20 unterschiedliche Türsystemtypen 70, 71 hinterlegt sind. Die Türsystemtypen 70, 71 sind erfindungsgemäß vorkonfiguriert. Hierdurch sind die Türkomponenten 33, 34, 35, 36, 37, 38, 39, 51, 52, 53, die bei Auswahl des Türsystemtyps 70, 71 zu installieren sind, fest vorgegeben.

In der ersten Datenbank 20 sind technische und/oder funktionale Benutzervorgaben hinterlegt, die mit den einzelnen Türsystemtypen 70, 71 verknüpft sind. Diese Verknüpfung wird in den Figuren 1 und 2 mit dem Bezugszeichen 80 bezeichnet. Auf der Anzeigevorrichtung 12 werden möglichen Benutzervorgaben einem Benutzer angezeigt. Der Benutzer kann Benutzervorgaben auswählen, die für die mit dem Türsystem 60, 61 auszustattende Tür zu erfüllen sind. Das Konfigurationssystem zeigt dem Benutzer nur diejenigen Türsystemtypen 70, 71 an, die den Benutzervorgaben entsprechen. Somit selektiert das Konfigurationssystem die Türsystemtypen 70, 71 vor. Aus den vorselektierten Türsystemtypen kann der Benutzer einen Türsystemtyp 70, 71 auswählen. Die Auswahl kann auch bedeuten, dass nur ein möglicher Türsystemtyp 70, 71 zur Auswahl bereitgestellt wird. Die Auswahl wird durch den Benutzer bestätigt.

Anschließend stellt die Recheneinheit 10 einem Benutzer, insbesondere einem Installateur, technische Daten 81, 82 in der Form eines Schaltplans 81 und von einer elektronischen Konfiguration 82 zur Verfügung. Die technischen Daten 81, 82 sind mit dem Türsystemtyp 70, 71 verknüpft. In der Figur 1 sind die technischen Daten 81, 82 in einer zweiten Datenbank 21 abgelegt. In Figur 2 ist der Schaltplan 81 in der ersten Datenbank 20 hinterlegt und die elektronische Konfiguration 82 in der zweiten Datenbank 21. Mittels der technischen Daten 81, 82 wird die Installation vor Ort durchgeführt.

Dadurch, dass fest vorgegebene und vorkonfigurierte Türsystemtypen 70, 71 verwendet werden, denen fest vorgegebene Benutzervorgaben und fest vorgegebene technische Daten 81, 82 zugeordnet sind, ist die Sicherheit des erfindungsgemäßen Zugangssystems 100 sehr hoch. So wird vermieden, dass Türkomponenten 33, 34, 35, 36, 37, 38, 39, 51, 52, 53, die nicht den Sicherheitsanforderungen entsprechen, installiert werden und/oder dass die Türkomponenten 33, 34, 35, 36, 37, 38, 39, 51, 52, 53 falsch installiert werden.

Das Konfigurationsprogramm ist für einen Benutzer nur nach einer Authentifizierung, z. B. nach einer Eingabe eines Benutzernamens und eines Passworts, zugänglich. In dem Konfigurationsprogramm ist mit jedem Benutzer eine Berechtigungsstufe verknüpft. Nur Benutzer einer ersten Berechtigungsstufe dürfen neue Türsystemtypen 70, 71 konfigurieren, die neuen Türsystemtypen mit Benutzervorgaben verknüpfen und die technischen Daten erstellen. Nur Benutzer der ersten und der zweiten Berechtigungsstufe dürfen Benutzervorgaben einstellen und einen hinterlegten Türsystemtyp auswählen. Benutzer einer dritten Berechtigungsstufe, die dem Installateur, der vor Ort die Installation durchführt, entspricht, dürfen nur zu einem bereits ausgewählten Türsystemtyp die technischen Daten herunterladen. Üblicherweise werden nur eine sehr geringe Anzahl an Benutzern Benutzer der ersten Berechtigungsstufe sein, da die Benutzer der ersten Berechtigungsstufe eine sehr hohe Fachqualifikation benötigen. Hierdurch ist die Sicherheit des Zugangssystems gewährleistet.

Ein Türsystem 60, 61 ist bevorzugt dadurch gekennzeichnet, dass jedes Türsystem 60, 61 eine gemeinsame elektronische Konfiguration umfasst. Die Konfiguration 82 ist als zumindest eine elektronische Datei ausgebildet und auf dem Steuergerät 30 speicherbar. Bevorzugt ist genau eine Konfiguration für jeden Türsystemtyp 70, 71 vorgesehen.

Ein Türsystem 60, 61 umfasst bevorzugt jeweils ein gemeinsames Steuergerät 30. Das Steuergerät dient zur Verbindung mit der Recheneinheit 10.

Ein Türsystem 60, 61 kann je nach Türsystemtyp 70, 71 zur Anordnung an einer oder an mehreren Türen vorgesehen sein. In einem weiteren, nicht dargestellten Ausführungsbeispiel dient ein Türsystem beispielsweise zur Anordnung an zwei hintereinander angeordneten Türen oder einem Hotelflur mit z. B. vier Zimmertüren.

Es kann sein, dass ein Zugangssystem 100 mehrere Türsysteme 60, 61 umfasst. Die Türsysteme 60, 61 können zu demselben oder unterschiedlichen Türsystemtypen 70, 71 gehören. Die Türsysteme 60, 61 sind bevorzugt über das zweite Bussystem 25 untereinander und/ mit der Recheneinheit 10 verbunden.

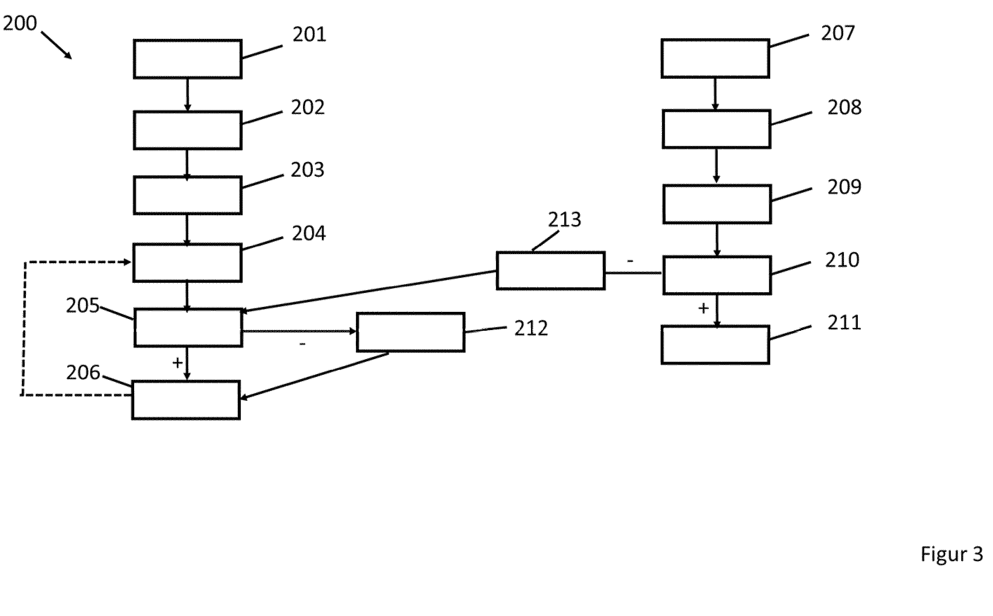

In Figur 3 ist ein erfindungsgemäßes Verfahren 200 dargestellt. In einem ersten Schritt 201 authentifiziert sich ein Benutzer der zweiten Berechtigungsstufe bei dem Konfigurationssystem. In einem zweiten Schritt 202 wird durch den authentifizierten Benutzer ein digitaler Bauplan in das Konfigurationssystem eingeladen. Der digitale Bauplan wird in der dritten Datenbank 22 hinterlegt. Die dritte Datenbank 22 dient dazu, zumindest Daten von einem Gebäudeabschnitt oder einem Gebäude zu speichern.

In einem dritte Schritt 203 legt der authentifizierte Benutzer zumindest einen Sicherheitsbereich auf dem digitalen Bauplan über die Eingabevorrichtung 13 fest, wobei der Sicherheitsbereich in dem Konfigurationssystem, insbesondere in der dritten Datenbank 22, gespeichert wird. In einem vierten Schritt 204 wählt der authentifizierte Benutzer eine Tür auf dem Bauplan, insbesondere eine Tür in dem Sicherheitsbereich, mittels der Eingabevorrichtung 13 aus und tätigt für die ausgewählte Tür technische und/oder funktionelle Benutzervorgaben über die Eingabevorrichtung 13. Hierzu stellt das Konfigurationssystem Benutzereingabeoptionen auf der Anzeigevorrichtung 12 zur Verfügung. In einem ersten Beispiel umfassen die Benutzervorgaben die Begriffe "Fluchtwegstür" und "einflügelig". In einem zweiten Beispiel umfassen die Benutzervorgaben die Begriffe "zweiflügelig", "mit Motorschloss", "mit Drehflügeltürantrieb".

In einem fünften Schritt 205 selektiert das Konfigurationssystem anhand der Benutzervorgaben passende Türsystemtypen 70, 71 und stellt diese dem Benutzer zur Auswahl bereit. In dem ersten Beispiel wird der Türsystemtyp 70 aus Figur 1 zur Auswahl bereitgestellt, nicht jedoch der Türsystemtyp 71 aus Figur 2. In dem zweiten Beispiel wird der Türsystemtyp 71 aus Figur 2 zur Auswahl bereitgestellt, nicht jedoch der Türsystemtyp 70 aus Figur 1. Der Schritt 205 entspricht dem Schritt a..

Wird als Benutzervorgabe in Schritt 204 eine "Fluchtwegtür" oder eine "Brandschutztür" gefordert, so wird in Schritt 205 ausschließlich der zumindest eine Türsystemtyp 70, 71 zur Auswahl bereitgestellt wird, der eine Vorgabe für den Gefahrenfall, die dem Schutz von Menschenleben dient, am Installationsort erfüllt.

Kann sich der Benutzer für den vorselektierten Türsystemtyp 70 oder 71 oder für einen der vorselektierten Türsystemtyp entscheiden, was in Figur 3 mit einem "+" dargestellt ist, so geht das Verfahren mit dem nächsten Schritt 206 weiter. Kann sich der Benutzer hingegen nicht für einen vorselektierten Türsystemtyp 70 oder 71 entscheiden oder existiert in der ersten Datenbank 21 kein Türsystemtyp 70, 71, die den Benutzervorgaben entspricht, was in Figur 3 mit einem "-" dargestellt ist, so kann in einem Schritt 212 der Benutzer der zweiten Berechtigungsstufe die Erstellung eines neuen Türsystemtyps 70, 71 anfordern. Hierbei teilt das Konfigurationssystem dem Benutzer der ersten Berechtigungsstufe die Benutzervorgaben mit. Ist der neue Türsystemtyp 70, 71 von dem Benutzer der ersten Berechtigungsstufe erstellt und kann sich der Benutzer der zweiten Berechtigungsstufe darauf dafür entscheiden, wird das Verfahren 200 ebenfalls mit dem Schritt 206 weitergeführt.

In dem Schritt 206 wird der ausgewählte Türsystemtyp 70, 71 der Tür auf dem digitalen Bauplan zugeordnet, insbesondere verlinkt. Des Weiteren wird eine Kennzeichnung für das Türsystem 60, 61 von dem Konfigurationssystem generiert, z. B. "Türsystem 325". Der ausgewählte Türsystemtyp, die Platzierung auf dem digitalen Bauplan und die Kennzeichnung des Türsystems 60, 61 werden in dem Konfigurationssystem elektronisch in der dritten Datenbank 22 gespeichert. Diese Gebäudeinformationen werden in den Figuren 1 und 2 mit dem Bezugszeichen 83 dargestellt. Optional werden die technischen Daten 81, 82 für das zu installierende Türsystem 60, 61 in der dritten Datenbank 22 gespeichert.

Optional kann der authentifizierte Benutzer nun eine weitere Tür auf dem digitalen Bauplan auswählen und die Schritte 204 bis 206 wiederholen sich für die weitere Tür. Dieses ist in Figur 3 gestrichelt dargestellt. Hierbei wird der bereits ausgewählte Türsystemtyp, also entweder der Türsystemtyp 70 oder 71 dem Benutzer als bevorzugte Option angezeigt. Dieses gilt insbesondere für eine Tür desselben Sicherheitsbereichs. Optional überprüft das Konfigurationssystem bei den ausgewählten Türsystemtypen 70, 71 für die weiteren Türen, ob die Türsystemtypen mit dem Installationsort oder untereinander konsistent sind. Hierzu kann beispielsweise eine Route auf dem Bauplan vorgegeben werden. Weicht ein Türsystemtyp 70, 71 auf der Route von den anderen Türsystemtypen 70, 71 auf der Route ab, so sendet das Konfigurationssystem eine Anfrage an den Benutzer.

Auf der Baustelle authentifiziert sich ein Installateur als ein Benutzer der dritten Berechtigungsstufe in dem Konfigurationssystem in einem Schritt 207. Der Installateur lädt in einem Schritt 208 aus der dritten Datenbank 22 als technische Daten einen Schaltplan 81 für das zu installierende Türsystem 60, 61 herunter. Dieses entspricht dem Schritt b.

Hierzu führt der Installateur ein mobiles Endgerät 50 mit sich (s. Figur 1 und 2). In einer ersten Option gibt der Installateur die Kennzeichnung des Türsystems 60, 61 in das mobile Endgerät 50 ein. In einer zweiten Alternative gibt der Installateur den Installationsort in das mobile Endgerät 50 an. Hierzu wird auf dem mobilen Endgerät der digitale Bauplan 81 angezeigt. In einer dritten Alternative gibt der Installateur den zu installierenden Türsystemtyp 70, 71 in das mobile Endgerät 50 ein. In jedem der Alternativen ist dem Konfigurationssystem nun der Türsystemtyp 70, 71 bekannt.

Daraufhin wird aus der ersten, zweiten oder dritten Datenbank 20, 21, 22 des Konfigurationssystems der Schaltplan 81 des Türsystemtyps 70, 71 auf das mobile Endgerät 50 geladen. Anhand des Schaltplans 81 kann der Installateur die Installation vornehmen.

In einem nächsten Schritt 209 wird in das installierte Steuergerät 30 eine elektronische Konfiguration des in Schritt 208 festgelegten Türsystemtyps 70, 71 aus der zweiten oder der dritten Datenbank 21, 22 des Konfigurationssystems in das Steuergerät 30 geladen. Dieses entspricht ebenfalls dem Schritt b. Hierbei kann entweder das mobile Endgerät 50 das Steuergerät 30 mit der Recheneinheit 10 verbinden oder das Steuergerät 30 ist über ein zweites Bussystem 25 mit der Recheneinheit 10 verbunden worden. Durch eine Eingabe auf dem mobilen Endgerät 50 kann der Installateur das Herunterladen der elektronischen Konfiguration 82 in das Steuergerät 30 bewirken.

Die elektronische Konfiguration 82 umfasst eine Aufstellung der Türkomponententypen 40, 41, 42, 43, 44, 45, 46, 47, 48, 49 und die Anzahl der zu installierenden Türkomponenten der jeweiligen Türkomponententypen 40, 41, 42, 43, 44, 45, 46, 47, 48, 49. Das Steuergerät 30 erhält in einem Schritt 210 über das erste Bussystem 32 automatisch Nachricht über die Türkomponententypen 40, 41, 44, 45, 46, 47 der an das erste Bussystem 32 weiteren angeschlossenen Türkomponenten 33, 34, 35, 36, 51, 52, 53. Hierzu senden die Türkomponenten 33, 34, 35, 36, 51, 52, 53 als Busteilnehmer eine Nachricht an das Steuergerät 30. Die an dem ersten Bussystem 32 teilnehmenden Türkomponenten 35, 36 melden die Türkomponententypen 42, 43 der weiteren Türkomponenten 37, 38, 39 an das Steuergerät 30. Hierzu haben die Türkomponenten 35, 36 zuvor überprüft, ob die Türkomponenten 37, 38, 39 angeschlossen sind. In einer weiteren Alternative sendet das Steuergerät 30 eine Anfrage an das mobile Endgerät 50, damit der Installateur über eine Eingabe an dem mobilen Endgerät 50 das Vorhandensein der Türkomponenten 37, 38, 39 bestätigt oder eine Handlung durchführt, die es den Türkomponenten 35, 36 ermöglicht, das Vorhanden Sein der Türkomponenten 37, 38, 39 festzustellen.

Ebenfalls erhält das Steuergerät 30 über das dritte Bussystem 55 Nachricht über den oder die angeschlossenen Leser 31. Das Steuergerät 30 vergleicht die installierten Türkomponententypen 40, 41, 42, 43, 44, 45, 46, 47, 38, 49 mit der Aufstellung.

In einer Alternative zum Schritt 210 umfasst die elektronische Konfiguration 82 nur eine Aufstellung der Türkomponententypen 40, 41, 44, 45, 46, 47, 48, 49 und die Anzahl der zu installierenden Türkomponenten der Türkomponententypen, die zur Teilnahme an dem ersten und/oder an dem dritten Bussystem 32, 55 bestimmt sind. Das Steuergerät 30 erhält über das erste Bussystem 32 automatisch Nachricht über die Türkomponententypen 40, 41, 44, 45, 46, 47, 48 der an das erste Bussystem 32 weiteren angeschlossenen Türkomponenten 33, 34, 35, 36, 51, 52, 53. Hierzu senden die Türkomponenten 33, 34, 35, 36, 51, 52, 53 als Busteilnehmer eine Nachricht an das Steuergerät 30. Ebenfalls erhält das Steuergerät 30 über das dritte Bussystem 55 Nachricht über den oder die angeschlossenen Leser 31. Es unterbleibt eine Nachricht der Türkomponenten 35, 36 an das Steuergerät 30 über die weiteren Türkomponenten 37, 38, 39. Nur die Türkomponententypen der an dem ersten und/oder dritten Bussystem 32, 55 teilnehmenden Türkomponenten 33, 34, 35, 36, 51, 52, 53 werden von dem Steuergerät 30 erfasst und mit der Aufstellung verglichen.

Ergibt der Vergleich der Aufstellung mit den Türkomponententypen der tatsächlich installierten Türkomponenten, dass die korrekten Türkomponententypen vorliegen, was in Figur 3 durch ein "+" dargestellt ist, so wird mit dem Installationsverfahren weiter in einem Schritt 211 fortgefahren. Ergibt hingegen der Vergleich, dass die installierten Türkomponententypen nicht mit der Aufstellung übereinstimmen, was in Figur 3 mit einem "-" dargestellt ist, wird das Installationsverfahren in einem Schritt 213 weiterverfahren. In dem Schritt 213 wird dem Benutzer der dritten Berechtigungsstufe auf dem mobilen Endgerät 50 von dem Steuergerät 30 mitgeteilt, dass die installierten Türkomponententypen nicht zu dem Türsystemtyp 70, 71 passen. Hierdurch wird die Installation vor Ort unterbrochen und das Steuergerät 30 fährt nicht mit dem Installationsverfahren fort.

Zugleich wird dem Benutzer der zweiten Berechtigungsstufe eine Nachricht gesendet, dass an dem Türsystem 60, 61 mit dem vergebenen Kennzeichen die Türkomponententypen nicht zu dem Türsystemtyp 70, 71 passen. Optional wird dem Benutzer der zweiten Berechtigungsstufe ein Vorschlag für einen passenden Türsystemtyp 70, 71 von dem Konfigurationssystem bereitgestellt. Dieses entspricht wiederum dem Schritt a. bzw. 205, da die Benutzervorgaben zur Vorselektion weiterhin gelten. Der Benutzer muss nun einen alternativen Türsystemtyp 70, 71 auswählen. Daraufhin erhält der Installateur in einem weiteren Schritt eine Nachricht, dass nun die Daten 81, 82 für das alternative Türsystemtyp 70, 71 herunterladen bereitstehen. Nun können die Schritte 208, 209, 210 wiederholt werden.

Ergibt der Vergleich der Aufstellung mit den Türkomponententypen der tatsächlich installierten Türkomponenten, dass die korrekten Türkomponententypen vorliegen, so wird in Schritt 211 eine eindeutige Kennzeichnung der verbauten Türkomponenten 33, 34, 35, 36, 37, 38, 39, 51, 52, 53, zumindest jedoch der verbauten Türkomponente 31, 33, 34, 35, 36, 51, 52, 53, die mit dem ersten und/oder dritten Bussystem 32, 55 verbunden sind, in der dritten Datenbank 22 als zu dem Türsystem 60, 61 gehörig hinterlegt. So können die Kennzeichnungen der Türkomponenten zu der Kennzeichnung des Türsystems 60, 61 oder zu dem Installationsort auf dem digitalen Bauplan zugeordnet sein.

Es kann vorgesehen sein, dass vor der Installation der Türkomponenten 33, 34, 35, 36, 37, 38, 39, 51, 52, 53 die eindeutige Kennzeichnung bereits in der Recheneinheit 10 hinterlegt ist. Der eindeutigen Kennzeichnung kann mit weiteren Merkmalen der Türkomponente verknüpft sein, beispielsweise mit dem Produktionsort und mit dem Produktionsdatum. Hierdurch hat die Recheneinheit stets Kenntnis davon, welche Türkomponente an welchem Installationsort installiert ist.

Ist jeder Türkomponententyp 40, 41, 44, 45, 46 in dem Türsystem 60 nur einmal vorhanden, wie in dem Ausführungsbeispiel der Figur 1, so melden zumindest die Türkomponenten 33, 35, 51, 52, 53, die mit dem ersten Bussystem 32 verbunden sind, sowohl den Türkomponententyp 40, 41, 44, 45, 46 als auch die eindeutige Kennzeichnung an das Steuergerät 30. Daraufhin sendet das Steuergerät 30 selbstständig über das mobile Endgerät 50 oder über das zweiten Bussystem 25 die Türkomponententypen und den zugeordneten eindeutigen Kennzeichnungen an die Recheneinheit 10. Ferner sendet das Steuergerät 30 die eigene eindeutige Kennzeichnung an die Recheneinheit 10. In der Recheneinheit 10 werden die Zuordnungen in der dritten Datenbank 22 gespeichert.

Sind Türkomponententypen 40, 41, 44, 45, 46 in dem Türsystem 60 mehrfach vorhanden, wie in dem Ausführungsbeispiel der Figur 2, so wird die Zuordnung durch eine Eingabe auf dem mobilen Endgerät 50 durchgeführt. Hierzu werden die eindeutigen Kennzeichnungen der mehrfach vorhandenen Türkomponenten 35, 36 dargestellt. Zudem werden auf dem Endgerät 50 die Türkomponententypen 41 und die vorgesehen Positionen dargestellt. Beispielsweise werden die beiden eindeutigen Kennzeichnungen "348.413" und "359.127" und die Begriffe "motorischer Türantrieb Gangflügel" und "motorischer Türantrieb Standflügel" angezeigt. Der Installateur kann eine Kennzeichnung auswählen. Hierauf gibt die dazugehörige Türkomponente 35, 36 ein visuelles und/oder akustisches Zeichen ab. Anhand des visuellen und/oder akustischen Zeichens kann der Installateur erkennen, an welcher Position sich die ausgewählte Türkomponente 35, 36 befindet, in diesem Bespiel, ob es sich um die ausgewählte Türkomponente der Türantrieb 35, 36 des Gangflügels oder des Standflügels handelt. Durch eine Eingabe auf dem mobilen Endgerät 50 kann der Installateur darauf die Zuordnung vornehmen, z. B. die Kennzeichnung "348.413" dem "motorischen Türantrieb Gangflügel" zuordnen.

Abweichend von dem geschilderten Ausführungsbeispiel kann vorgesehen sein, dass nicht jede Abweichung der tatsächlich installierten Türkomponenten von der Aufstellung dazu führt, dass ein alternativer Türsystemtyp 70, 71 für den Installationsort bestimmt werden muss. Vielmehr ist insbesondere bei mechanisch abweichenden Türkomponenten oder höherwertigen Türkomponenten denkbar, dass sich dennoch Schritt 211 an Schritt 210 anschließt.

Abweichend von dem geschilderten Ausführungsbeispiel kann es sein, dass der Installateur zusätzlichen Informationen in der dritten Datenbank 22 hinterlegen darf. Diese betreffen z. B. die räumlichen Ausmaße der verwendeten Türkomponenten.

## Patentansprüche

1. Verfahren (200) zur Installation von mehreren Türkomponenten (30, 31, 33, 34, 35, 36, 37, 38, 39, 51, 52, 53)
wobei das Verfahren (200) zumindest die folgenden Schritte umfasst:
a. Bereitstellen von zumindest einem vorkonfigurierten Türsystemtyp (70, 71) durch ein elektronisches Konfigurationssystem zur Auswahl durch einen Benutzer,
wobei der zumindest eine vorkonfigurierte Türsystemtyp (70, 71) durch das elektronische Konfigurationssystem von einer Datenbank (20) abrufbar ist, wobei durch zumindest eine technische und/oder funktionale Benutzervorgabe zumindest ein vorkonfigurierter Türsystemtyp (70, 71) durch das elektronische Konfigurationssystem vorselektierbar ist,
wobei der Türsystemtyp (70, 71) mehrere festgelegte Türkomponententypen (40, 41, 42, 43, 44, 45, 46, 47, 48, 49) enthält,
b. Elektronische Zurverfügungstellung von vorkonfigurierten, technischen Daten (81, 82) des ausgewählten Türsystemtyps (70, 71), um die Installation vor Ort durchzuführen,
wobei die Daten (81, 82) eine elektronische Konfiguration (82) des Türsystems (60, 61) umfassen.

2. Verfahren (200) nach Anspruch 1, wobei, wenn die Benutzereingabe den Einsatz für einen Gefahrenfall, insbesondere den Einsatz zur Bereitstellung eines Fluchtwegs und/oder eines Brandschutzes, umfasst, in Schritt a. ausschließlich der zumindest eine Türsystemtyp (70, 71) zur Auswahl bereitgestellt wird, der eine Vorgabe für den Gefahrenfall, die dem Schutz von Menschenleben dient, am Installationsort erfüllt.

3. Verfahren (200) nach Anspruch 1 oder 2, wobei vor Schritt a. ein digitaler Bauplan in das elektronische Konfigurationssystem eingelesen wird, wobei nach Schritt a. die ausgewählten Türsystemtypen (70, 71) verschiedenen Installationsorten zugeordnet sind, wobei das Konfigurationssystem elektronisch überprüft, ob die ausgewählten Türsystemtypen (70, 71) zu dem Installationsort konsistent sind oder zu Türsystemtypen (70, 71), die auf einer begehbaren Route auf dem Bauplan liegen, konsistent sind.

4. Verfahren (200) nach einem der vorhergehenden Ansprüche, wobei derselbe Türsystemtyp (70, 71) von dem Konfigurationssystem automatisch für weitere Türen eines räumlichen Bereichs in Schritt a. bereitgestellt wird, wobei insbesondere die Art der Bereitstellung dem auswählenden Benutzer anzeigt, dass der Türsystemtyp (70, 71) bereits verwendet worden ist, und/oder wobei für einen Benutzer oder eine Benutzergruppe eine reduzierte Anzahl von Türsystemtypen (70, 71) zur Vorselektion durch das elektronische Konfigurationssystem zur Verfügung steht.

5. Verfahren (200) nach einem der vorhergehenden Ansprüche, wobei das elektronische Konfigurationssystem mehrere Berechtigungsstufen umfasst, wobei jedem Benutzer eine Berechtigungsstufe zugeordnet ist, wobei zumindest zwei, bevorzugt alle, der folgenden Berechtigungsstufen vorgesehen sind:
• eine erste Berechtigungsstufe, die das Erstellen eines neuen Türsystemtyps (70, 71) erlaubt,
• eine zweite Berechtigungsstufe, die die Auswahl eines vorkonfigurierten Türsystemtyps (70, 71) und/oder das Einstellen von Benutzervorgaben erlaubt, nicht jedoch das Erstellen eines neuen Türsystemtyps (70, 71),
• eine dritte Berechtigungsstufe, die das Abrufen von Daten (81, 82) des ausgewählten Türsystemtyps (70, 71) erlaubt, nicht jedoch die Auswahl des Türsystemtyps 70, 71), das Einstellen von Benutzervorgaben oder das Erstellen eines neuen Türsystemtyps (70, 71),
wobei die Berechtigungsstufen in dem elektronischen Konfigurationssystem festgelegt sind, wobei die Berechtigungsstufen mit einer Authentifizierung des Benutzers verknüpft sind.

6. Verfahren (200) nach einem der vorhergehenden Ansprüche, wobei die vorkonfigurierten technischen Daten (81, 82), die in Schritt b. zur Verfügung gestellt werden, mit dem Türsystemtyp (70, 71) verknüpft (80) in einer Datenbank (20, 21) hinterlegt sind, wobei die vorkonfigurierten Daten (81, 82) mehrere Türkomponenten (30, 31, 33, 34, 35, 36, 37, 38, 39, 51, 52, 53) eines Türsystems (60, 61) betreffen, wobei die vorkonfigurierten Daten (81, 82) bei einer Eingabe eines Benutzers aus der Datenbank (20, 21) einsehbar und/oder herunterladbar sind, wobei die Eingabe den Türsystemtyp (70, 71) oder eine Angabe, die mit dem Türsystemtyp (70, 71) verknüpft ist, insbesondere ein Installationsort oder eine Kennzeichnung des Türsystems (60, 61), beinhaltet.

7. Verfahren (200) nach einem der vorhergehenden Ansprüche, wobei die vorkonfigurierten Daten (81, 82) einen Schaltplan (81) des Türsystems (60, 61) umfassen, wobei der Schaltplan (81) aus dem Konfigurationssystem und/oder aus einer Datenbank (20, 21) auf ein mobiles Endgerät (50) einsehbar und/oder herunterladbar ist, wobei der Installationsort auf dem digitalen Bauplan, der Türsystemtyp (70, 71) oder eine Kennzeichnung des Türsystems (60, 61) in das mobile Endgerät (50) eingegeben wird.

8. Verfahren (200) nach einem der vorhergehenden Ansprüche, wobei die elektronische Konfiguration (82) zumindest eine, bevorzugt mehrere, besonders bevorzugt alle, der folgenden elektronischen Daten umfassen:
• Vorgesehene Türkomponententypen (40, 41, 42, 43, 44, 45, 46, 47, 48, 49) des Türsystems (60, 61)
• Sender und/oder Empfänger von Nachrichten innerhalb des Türsystems (60, 61)
• Funktionsabläufe des Türsystems (60, 61), bei dem mehrere Vorgänge in einer vorgegebenen Reihenfolge durchzuführen sind
• Parameter zum Betrieb des Türsystems (60, 61)
• einen Testablauf für das Türsystem (60, 61), bei dem zur Inbetriebnahme zumindest einer Funktion oder einen Funktionsablauf des Türsystems (60, 61) getestet wird.

9. Verfahren nach einem der vorhergehenden Ansprüche, wobei eine Türkomponente als ein Steuergerät (30) ausgebildet ist, wobei die elektronische Konfiguration (82) des Türsystems (60, 61) in dem Steuergerät (30) gespeichert wird und/oder wobei weitere Türkomponenten (31, 33, 34, 35, 36, 37, 38, 39, 51, 52, 53) zu zumindest einer Türkomponentengruppe, bevorzugt zu mehreren der folgenden Türkomponentengruppen gehören:
• motorischer Türantrieb (35, 36)
• Verriegelungselement (33, 34, 52)
• Signalgeber (30, 37, 38, 51, 53) zum Öffnen, Anhalten, Schließen, Verriegeln oder Entriegeln einer Tür, insbesondere einen Sensor (37, 38), eine Authentifizierungsvorrichtung (30), eine Fluchtwegsteuerung (51) oder einen Gefahrenmelder (53),
• Erfassungseinheit (31) zum Empfang eines Zutrittsattributs.

10. Verfahren (200) nach einem der vorhergehenden Ansprüche, wobei ein Steuergerät (30), Kenntnis von den in dem Türsystem (60, 61) tatsächlich verbauten Türkomponententypen (40, 41, 42, 43, 44, 45, 46, 47, 48, 49) hat und mit vorgesehenen Türkomponententypen (40, 41, 42, 43, 44, 45, 46, 47, 48, 49) des Türsystem (60, 61) in der elektronischen Konfiguration (82) vergleicht, wobei bei einer Abweichung der verbauten Türkomponententypen (40, 41, 42, 43, 44, 45, 46, 47, 48, 49) mit den vorgesehenen Türkomponententypen(40, 41, 42, 43, 44, 45, 46, 47, 48, 49) elektronisch hinterlegt vordefiniert ist, wie das Installationsverfahren weiterzuführen ist.

11. Verfahren (200) nach Anspruch 10, wobei bei einer definierten Abweichung die Aufnahme eines Betriebs des Türsystems (60, 61) elektronisch verhindert ist, wobei bei Vorliegen der vorgegebenen Abweichung die Verwendung eines alternativen Türsystemtyps (70, 71), das den tatsächlich verbauten Türkomponententypen(40, 41, 42, 43, 44, 45, 46, 47, 48, 49) entspricht, in dem Konfigurationssystem geprüft wird, wobei anschließend die verbauten Türkomponenten (40, 41, 42, 43, 44, 45, 46, 47, 48, 49) als Teil des alternativen Türsystemtyps (70, 71) mit der elektronischen Konfiguration des alternativen Türsystemtyps (70, 71) installiert werden.

12. Verfahren (200) nach einem der vorhergehenden Ansprüche 10 bis 11, wobei das Steuergerät (30) Kenntnis von in dem Türsystem (60, 61) tatsächliche verbauten Türkomponententypen (40, 41, 42, 43, 44, 45, 46, 47, 48, 49) hat, indem weiteren Türkomponenten (31, 33, 34, 35, 36, 37, 38, 39, 51, 52, 53) sich bei dem Steuergerät (30) unter Angabe des Türkomponententyps (40, 41, 42, 43, 44, 45, 46, 47, 48, 49) anmelden, wobei insbesondere weiteren Türkomponenten und das Steuergerät mit einem Bussystem (32, 55) verbunden sind.

13. Verfahren (200) nach einem der vorhergehenden Ansprüche, wobei vor Schritt a. in dem Zugangssystem (100), insbesondere in einer Recheneinheit (10), eine Kennzeichnung der verbauten Türkomponente (30, 31, 33, 34, 35, 36, 37, 38, 39, 51, 52, 53) zusammen mit zumindest einem weiteren Merkmal der Türkomponente, insbesondere dem Türkomponententyp (40, 41, 42, 43, 44, 45, 46, 47, 48, 49), hinterlegt ist, wobei am Ende der Installation die Kennzeichnung von verbauten Türkomponenten (30, 31, 33, 34, 35, 36, 37, 38, 39, 51, 52, 53) einer Kennzeichnung des Türsystems (60, 61) zugeordnet und in der Recheneinheit (10) hinterlegt ist.

14. Computerprogrammprodukt zur Durchführung des Verfahrens (200) nach einem der Ansprüche 1 bis 13.

15. Recheneinheit (10) oder Zugangssystem (100) zur Durchführung des Verfahrens (200) nach einem der Ansprüche 1 bis 13.

## Claims

1. A method (200) for installing a plurality of door components (30, 31, 33, 34, 35, 36, 37, 38, 39, 51, 52, 53)
wherein the method (200) comprises at least the following steps:
a. providing at least one preconfigured door system type (70, 71) by way of an electronic configuration system for selection by a user,
wherein the at least one preconfigured door system type (70, 71) can be retrieved from a database (20) by the electronic configuration system, wherein at least one preconfigured door system type (70, 71) can be preselected by the electronic configuration system by way of at least one technical and/or functional user specification,
wherein the door system type (70, 71) includes a plurality of defined door component types (40, 41, 42, 43, 44, 45, 46, 47, 48, 49),
b. electronically providing preconfigured technical data (81, 82) of the selected door system type (70, 71) in order to carry out the installation on site, wherein the data (81, 82) comprises an electronic configuration (82) of the door system (60, 61).

2. The method (200) according to claim 1, wherein, if the user input comprises the use for a hazardous situation, in particular the use to provide an escape route and/or fire protection, in step a. only the at least one door system type (70, 71) is made available for selection, which fulfils a specification for the hazardous situation at the installation location, which serves to protect human life.

3. The method (200) according to claim 1 or 2, wherein prior to step a., a digital building plan is read into the electronic configuration system, wherein after step a., the selected door system types (70, 71) are assigned to different installation locations, wherein the configuration system verifies electronically whether the selected door system types (70, 71) are consistent with the installation location or are consistent with door system types (70, 71) that are on a walkable route on the building plan.

4. The method (200) according to one of the preceding claims, wherein the same door system type (70, 71) is automatically provided by the configuration system for further doors of a spatial region in step a., wherein in particular the type of provision indicates to the selecting user that the door system type (70, 71) has already been used, and/or wherein a reduced number of door system types (70, 71) are available for preselection for a user or a user group through the electronic configuration system.

5. The method (200) according to one of the preceding claims, wherein the electronic configuration system comprises a plurality of authorisation levels, wherein each user is assigned to an authorisation level, wherein at least two, preferably all, of the following authorisation levels are provided:
• a first authorisation level that allows a new door system type (70, 71) to be created,
• a second authorisation level that allows a preconfigured door system type (70, 71) to be selected and/or user specifications to be set, but not a new door system type (70, 71) to be created,
• a third authorisation level that allows data (81, 82) of the selected door system type (70, 71) to be retrieved, but not the door system type 70, 71) to be selected, user specifications to be set or a new door system type (70, 71) to be created,
wherein the authorisation levels are defined in the electronic configuration system, wherein the authorisation levels are linked to an authentication of the user.

6. The method (200) according to one of the preceding claims, wherein the preconfigured technical data (81, 82) provided in step b. linked (80) to the door system type (70, 71) is stored in a database (20, 21), wherein the preconfigured data (81, 82) relates to a plurality of door components (30, 31, 33, 34, 35, 36, 37, 38, 39, 51, 52, 53) of a door system (60, 61), wherein the preconfigured data (81, 82) can be viewed and/or downloaded from the database (20, 21) upon input by a user, wherein the input includes the door system type (70, 71) or an indication linked to the door system type (70, 71), in particular an installation location or an identifier of the door system (60, 61).

7. The method (200) according to one of the preceding claims, wherein the preconfigured data (81, 82) comprises a circuit diagram (81) of the door system (60, 61), wherein the circuit diagram (81) can be viewed and/or downloaded from the configuration system and/or from a database (20, 21) onto a mobile terminal (50), wherein the installation location on the digital building plan, the door system type (70, 71) or an identifier of the door system (60, 61) is input into the mobile terminal (50).

8. The method (200) according to one of the preceding claims, wherein the electronic configuration (82) comprises at least one, preferably a plurality, particularly preferably all, of the following electronic data:
• provided door component types (40, 41, 42, 43, 44, 45, 46, 47, 48, 49) of the door system (60, 61)
• transmitters and/or receivers of messages within the door system (60, 61)
• functional processes of the door system (60, 61), in which a plurality of processes are to be carried out in a specified order
• parameters for operating the door system (60, 61)
• a test process for the door system (60, 61), in which at least one function or a functional process of the door system (60, 61) is tested for commissioning.

9. The method according to one of the preceding claims, wherein a door component is designed as a control unit (30), wherein the electronic configuration (82) of the door system (60, 61) is stored in the control unit (30) and/or wherein further door components (31, 33, 34, 35, 36, 37, 38, 39, 51, 52, 53) belong to at least one door component group, preferably to a plurality of the following door component groups:
• motorised door drive (35, 36)
• locking element (33, 34, 52)
• signal transmitter (30, 37, 38, 51, 53) for opening, stopping, closing, locking or unlocking a door, in particular a sensor (37, 38), an authentication device (30), an escape route controller (51) or a hazard detector (53),
• detection unit (31) for receiving an access attribute.

10. The method (200) according to one of the preceding claims, wherein a control unit (30) has knowledge of the door component types (40, 41, 42, 43, 44, 45, 46, 47, 48, 49) actually installed in the door system (60, 61) and compares it with provided door component types (40, 41, 42, 43, 44, 45, 46, 47, 48, 49) of the door system (60, 61) in the electronic configuration (82), wherein if the installed door components types (40, 41, 42, 43, 44, 45, 46, 47, 48, 49) deviate from the provided door component types (40, 41, 42, 43, 44, 45, 46, 47, 48, 49), it is predefined in an electronically stored manner how the installation process is to be continued.

11. The method (200) according to claim 10, wherein the start-up of an operation of the door system (60, 61) is electronically prevented in the event of a defined deviation, wherein, if there is a defined deviation, the use of an alternative door system type (70, 71) which corresponds to the actually installed door component types (40, 41, 42, 43, 44, 45, 46, 47, 48, 49) is checked in the configuration system, wherein the installed door components (40, 41, 42, 43, 44, 45, 46, 47, 48, 49) are then installed as part of the alternative door system type (70, 71) with the electronic configuration of the alternative door system type (70, 71).

12. The method (200) according to one of the preceding claims 10 to 11, wherein the control unit (30) has knowledge of door component types (40, 41, 42, 43, 44, 45, 46, 47, 48, 49) actually installed in the door system (60, 61), in that further door components (31, 33, 34, 35, 36, 37, 38, 39, 51, 52, 53) register with the control unit (30) by specifying the door component type (40, 41, 42, 43, 44, 45, 46, 47, 48, 49), wherein in particular further door components and the control unit are connected to a bus system (32, 55).

13. The method (200) according to one of the preceding claims, wherein prior to step a., an identifier of the installed door component (30, 31, 33, 34, 35, 36, 37, 38, 39, 51, 52, 53) is stored in the access system (100), in particular in a computing unit (10), together with at least one other feature of the door component, in particular the door component type (40, 41, 42, 43, 44, 45, 46, 47, 48, 49), wherein at the end of the installation, the identifier of installed door components (30, 31, 33, 34, 35, 36, 37, 38, 39, 51, 52, 53) is assigned to an identifier of the door system (60, 61) and stored in the computing unit (10).

14. A computer program product for carrying out the method (200) according to one of claims 1 to 13.

15. A computing unit (10) or access system (100) for carrying out the method (200) according to one of claims 1 to 13.

## Revendications

1. Procédé (200) pour l'installation de plusieurs composants de porte (30, 31, 33, 34, 35, 36, 37, 38, 39, 51, 52, 53)
dans lequel le procédé (200) comprend au moins les étapes suivantes :
a. fourniture d'au moins un type de système de porte (70, 71) préconfiguré par un système de configuration électronique pour la sélection par un utilisateur,
dans lequel l'au moins un type de système de porte (70, 71) préconfiguré peut être appelé par le système de configuration électronique à partir d'une base de données (20), dans lequel au moins un type de système de porte (70, 71) préconfiguré peut être présélectionné par le système de configuration électronique par au moins une consigne d'utilisateur technique et/ou fonctionnelle,
dans lequel le type de système de porte (70, 71) contient une pluralité de types de composants de porte (40, 41, 42, 43, 44, 45, 46, 47, 48, 49) établis,
b. mise à disposition électronique de données (81, 82) techniques préconfigurées du type de système de porte (70, 71) sélectionné afin de réaliser l'installation sur place,
dans lequel les données (81, 82) comprennent une configuration électronique (82) du système de porte (60, 61).

2. Procédé (200) selon la revendication 1, dans lequel, si l'entrée d'utilisateur contient
l'utilisation pour un cas de danger, en particulier l'utilisation pour la fourniture d'une voie d'évacuation et/ou d'une protection contre l'incendie, à l'étape a. exclusivement l'au moins un type de système de porte (70, 71) qui remplit une prescription pour le cas de danger, qui sert à la protection de vies humaines, est fourni pour la sélection sur le lieu d'installation.

3. Procédé (200) selon la revendication 1 ou 2, dans lequel, avant l'étape a., un plan de construction numérique est lu dans le système de configuration électronique, dans lequel, après l'étape a., les types de systèmes de portes (70, 71) sélectionnés sont associés à différents lieux d'installation, dans lequel le système de configuration vérifie électroniquement si les types de systèmes de portes (70, 71) sélectionnés sont cohérents avec le lieu d'installation ou sont cohérents avec des types de systèmes de portes (70, 71) qui se trouvent sur un itinéraire praticable sur le plan de construction.

4. Procédé (200) selon l'une des revendications précédentes, dans lequel le même type de système de porte (70, 71) est automatiquement fourni par le système de configuration pour d'autres portes d'une zone spatiale à l'étape a., dans lequel en particulier le mode de fourniture indique à l'utilisateur qui effectue la sélection que le type de système de porte (70, 71) a déjà été utilisé, et/ou dans lequel un nombre réduit de types de systèmes de porte (70, 71) est mis à disposition pour un utilisateur ou un groupe d'utilisateurs pour une présélection par le système de configuration électronique.

5. Procédé (200) selon l'une des revendications précédentes, dans lequel le système de configuration électronique comprend plusieurs niveaux d'autorisation, dans lequel un niveau d'autorisation est attribué à chaque utilisateur, dans lequel au moins deux des niveaux d'autorisation suivants, de préférence tous, sont prévus :
• un premier niveau d'autorisation, qui permet la création d'un nouveau type de système de porte (70, 71),
• un deuxième niveau d'autorisation qui permet la sélection d'un type de système de porte (70, 71) préconfiguré et/ou la définition de consignes d'utilisateur, mais pas la création d'un nouveau type de système de porte (70, 71),
• un troisième niveau d'autorisation qui permet l'appel de données (81, 82) du type de système de porte (70, 71) sélectionné, mais pas la sélection du type de système de porte (70, 71), la définition de consignes d'utilisateur ou la création d'un nouveau type de système de porte (70, 71),
dans lequel les niveaux d'autorisation sont établis dans le système de configuration électronique, dans lequel les niveaux d'autorisation sont associés à une authentification de l'utilisateur.

6. Procédé (200) selon l'une des revendications précédentes, dans lequel les données (81, 82) techniques préconfigurées qui ont été mises à disposition à l'étape b. sont enregistrées dans une base de données (20, 21) rattachées (80) au type de système de porte (70, 71), dans lequel les données (81, 82) préconfigurées concernent plusieurs composants de porte (30, 31, 33, 34, 35, 36, 37, 38, 39, 51, 52, 53) d'un système de porte (60, 61), dans lequel les données (81, 82) préconfigurées peuvent être lus et/ou téléchargées à partir de la base de données (20, 21) lors d'une entrée par un utilisateur, dans lequel l'entrée contient le type de système de porte (70, 71) ou une indication, qui est rattachée au type de système de porte (70, 71), en particulier un lieu d'installation ou une identification du système de porte (60, 61).

7. Procédé (200) selon l'une des revendications précédentes, dans lequel les données (81, 82) préconfigurées comprennent un schéma de câblage (81) du système de porte (60, 61), dans lequel le schéma de câblage (81) peut être lu et/ou téléchargé sur un terminal mobile (50) à partir du système de configuration et/ou d'une base de données (20, 21), dans lequel le lieu d'installation sur le plan de construction numérique, le type de système de porte (70, 71) ou une identification du système de porte (60, 61) est entré dans le terminal mobile (50).

8. Procédé (200) selon l'une des revendications précédentes, dans lequel la configuration électronique (82) comprend au moins une, de préférence plusieurs, de manière particulièrement préférée toutes, les données électroniques suivantes :
• types de composants de porte (40, 41, 42, 43, 44, 45, 46, 47, 48, 49) prévus du système de porte (60, 61)
• émetteur et/ou récepteur de messages à l'intérieur du système de porte (60, 61)
• déroulement des fonctions du système de porte (60, 61), dans lequel plusieurs opérations doivent être réalisées dans un ordre prédéfini
• paramètres de fonctionnement du système de porte (60, 61)
• une procédure de test pour le système de porte (60, 61), dans laquelle on teste pour la mise en service au moins une fonction ou un déroulement des fonctions du système de porte (60, 61).

9. Procédé selon l'une des revendications précédentes, dans lequel un composant de porte est conçu comme un appareil de commande (30), dans lequel la configuration électronique (82) du système de porte (60, 61) est mémorisée dans l'appareil de commande (30) et/ou dans lequel d'autres composants de porte (31, 33, 34, 35, 36, 37, 38, 39, 51, 52, 53) appartiennent à au moins un groupe de composants de porte, de préférence à plusieurs des groupes de composants de porte suivants :
• entraînement de porte motorisé (35, 36)
• élément de verrouillage (33, 34, 52)
• générateur de signaux (30, 37, 38, 51, 53) pour ouvrir, arrêter, fermer, verrouiller ou déverrouiller une porte, en particulier un capteur (37, 38), un dispositif d'authentification (30), une commande d'issue de secours (51) ou un détecteur de danger (53),
• unité de détection (31) pour recevoir un attribut d'accès.

10. Procédé (200) selon l'une des revendications précédentes, dans lequel un appareil de commande (30) a connaissance des types de composants de porte (40, 41, 42, 43, 44, 45, 46, 47, 48, 49) effectivement montés dans le système de porte (60, 61) et les compare aux types de composants de porte (40, 41, 42, 43, 44, 45, 46, 47, 48, 49) prévus du système de porte (60, 61) dans la configuration électronique (82), dans lequel en cas de divergence entre les types de composants de porte (40, 41, 42, 43, 44, 45, 46, 47, 48, 49) montés et les types de composants de porte (40, 41, 42, 43, 44, 45, 46, 47, 48, 49) prévus, il est prédéfini, de manière enregistrée électroniquement, comment le procédé d'installation doit être poursuivi.

11. Procédé (200) selon la revendication 10, dans lequel, en cas de divergence définie, la prise en charge d'un fonctionnement du système de porte (60, 61) est empêchée électroniquement, dans lequel, en présence de la divergence prédéfinie, l'utilisation d'un type de système de porte (70, 71) alternatif, qui correspond aux types de composants de porte (40, 41, 42, 43, 44, 45, 46, 47, 48, 49) effectivement montés est testée dans le système de configuration, dans lequel ensuite les composants de porte (40, 41, 42, 43, 44, 45, 46, 47, 48, 49) montés sont installés en tant que partie du type de système de porte (70, 71) alternatif avec la configuration électronique du type de système de porte (70, 71) alternatif.

12. Procédé (200) selon l'une des revendications précédentes 10 à 11, dans lequel l'appareil de commande (30) a connaissance de types de composants de porte (40, 41, 42, 43, 44, 45, 46, 47, 48, 49) effectivement montés dans le système de porte (60, 61), en ce que d'autres composants de porte (31, 33, 34, 35, 36, 37, 38, 39, 51, 52, 53) s'annoncent auprès de l'appareil de commande (30) en indiquant le type de composant de porte (40, 41, 42, 43, 44, 45, 46, 47, 48, 49), dans lequel d'autres composants de porte et l'appareil de commande sont en particulier reliés par un système de bus (32, 55).

13. Procédé (200) selon l'une des revendications précédentes, dans lequel, avant l'étape a. dans le système d'accès (100), en particulier dans une unité de calcul (10), une identification du composant de porte (30, 31, 33, 34, 35, 36, 37, 38, 39, 51, 52, 53) monté, conjointement avec au moins une autre caractéristique du composant de porte, en particulier le type de composant de porte (40, 41, 42, 43, 44, 45, 46, 47, 48, 49), est enregistré, dans lequel l'identification de composants de porte (30, 31, 33, 34, 35, 36, 37, 38, 39, 51, 52, 53) montés est attribuée à la fin de l'installation à une identification du système de porte (60, 61) et est enregistrée dans l'unité de calcul (10).

14. Produit programme d'ordinateur pour la réalisation du procédé (200) selon l'une des revendications 1 à 13.

15. Unité de calcul (10) ou système d'accès (100) pour la réalisation du procédé (200) selon l'une des revendications 1 à 13.
